# EUROPEAN PATENT APPLICATION

(11) **EP 0 614 216 A1**
(43) Date of publication of application: **07.09.1994**
(21) Application number: 92924004.2
(22) Date of filing: 24.11.1992
(51) Int. Cl.: H01L 21/316, H01L 21/00, C23C 16/44, C30B 33/00

(54) **APPARATUS FOR FORMING OXIDE FILM, HEAT TREATMENT APPARATUS, SEMICONDUCTOR DEVICE, MANUFACTURING METHOD THEREFOR**

(30) Priority: 22.11.1991 JP 334260/91; 22.11.1991 JP 334261/91; 22.11.1991 JP 334263/91; 29.11.1991 JP 342229/91
(71) Applicant: OHMI, Tadahiro, Sendai-shi Miyagi-ken 980 (JP)
(72) Inventor: OHMI, Tadahiro, Sendai-shi Miyagi-ken 980 (JP)
(74) Representative: Weitzel, Wolfgang, Dr.-Ing. Patentanwalt
(86) International application number: JP9201534
(87) International publication number: WO9310556

(57) **Abstract**

A heat treatment apparatus which can perform active gas sintering, etc. for forming a reliable oxide film on the surface of a substrate in a furnace tube. In the apparatus, provided are at least a furnace tube (1) which has a closable opening part (11) for loading in and out an object (5) to be treated and has gas introducing inlets (12) for introducing gases inside, a heating means (4) for heating the inside of the furnace tube (1), gas introducing pipes (2) communicating with the gas introducing inlets (12) so as to pass gases through them, and a heating means (9) for heating the gas introducing pipes (2). At least the inner surfaces of the gas introducing pipes (2) are made of nickel or a material containing nickel.

## Description

### Technical Field

The present invention relates to an apparatus for forming oxide film, and a heat treatment apparatus such as a sintering apparatus which are generally used for, for example, a semiconductor manufacturing process.

Moreover, the present invention relates to a semiconductor device and its manufacturing method, particularly to a semiconductor device and its manufacturing method capable of forming an oxide film/silicon interface with a high reliability.

### Background Art

### (Apparatus for forming oxide film)

Conventionally, for example, a heat oxidation furnace system is constituted so as to bring gaseous matter and water vapor into contact with a heated silicon substrate by introducing a mixed gas of oxygen gas and hydrogen gas into a furnace tube comprising a quartz tube heated by means of the electrical resistance heating method to burn the hydrogen and thereby generate water vapor, in order to form an oxide film on the surface of the silicon substrate.

For the existing system, however, because the introduced hydrogen gas burns at the tip of the quartz tube serving as the furnace tube, the tip of the quartz tube is melted, many particles are produced, and the particles cause the silicon substrate to be contaminated.

In this case, to form an oxide film with a high reliability, the furnace tube for taking charge of an oxidation process must not be contaminated by the particles but it should be cleaned as soon as possible.

To manufacture an electrically stable semiconductor device, it is also necessary to remove the particles from the silicon substrate as soon as possible.

Therefore, super-cleaning of a thermal oxide film forming process is indispensable to obtain a super-fine LSI.

The present invention is made to solve the above problem and its object is to provide a apparatus for forming oxide film allowing wet oxidation treatment to form an oxide film with a high reliability on a substrate in a furnace tube.

### (Heat treatment apparatus)

The prior art is described below by taking a sintering apparatus for terminating a dangling bond on oxide film/silicon interface by hydrogen as an example.

As this type of sintering apparatus, an apparatus is hitherto known which is constituted so as to terminate a dangling bond by hydrogen by introducing hydrogen gas or a mixed gas of an inert gas and hydrogen gas into a furnace tube comprising a quartz tube heated by the electrical resistance heating method and bringing the gas into contact with an oxide film/silicon substrate.

Moreover, an apparatus is also known which is constituted so as to terminate a dangling bond by hydrogen by transforming hydrogen gas or a mixed gas of an inert gas and hydrogen gas into plasma and bringing hydrogen ions and hydrogen activation seeds in the plasma into contact with an oxide film/silicon substrate.

For the former apparatus, however, termination of the dangling bond on the oxide film/silicon interface is insufficient and no high-reliability device can be manufactured because the introduced gas is not active.

For the latter apparatus, the dangling bonds are adequately terminated because hydrogen activation seeds in the plasma are used for the termination and thereby it is expected that a high-reliability device can be obtained. However, it is clarified that a high-reliability device cannot always be obtained when the dangling bonds are actually terminated by the latter apparatus. The inventor of the present invention studied the cause that no high-reliability device can be obtained contrary to expectation. As a result, it is clarified that the cause lies in the fact that, because the latter apparatus generates plasma, the plasma damages the oxide film and the oxide film/silicon interface and thereby defects and dangling bonds are newly produced.

After all, there is no technique for adequately terminating the dangling bonds without damaging the oxide film and the oxide film/silicon interface at present.

To solve the above problem, it is an object of the present invention to provide a heat treatment apparatus for realizing active gas sintering in order to form a high-reliability oxide film on the surface of a substrate in a furnace tube.

### (Semiconductor device manufacturing method)

The prior art is described below by using an oxide film as an insulating film and silicon as semiconductor.

The sintering method is hitherto known as one of the methods for terminating dangling bonds on an oxide film/silicon interface. This is a method for terminating dangling bonds on an oxide film/silicon interface by hydrogen by forming an oxide film or an oxide film, electrode, and wiring on a silicon substrate and thereafter bringing a mixed gas of hydrogen gas and inert gas into contact with the heated silicon substrate.

A technique is also known for terminating dangling bonds by hydrogen by transforming hydrogen gas or a mixed gas of an inert gas and hydrogen gas into plasma and bringing hydrogen ions and hydrogen seeds in the plasma into contact with an oxide film/silicon substrate.

For the former technique, however, termination of the dangling bonds on the oxide film/silicon interface is insufficient and therefore not high-reliability device can be manufactured because the introduced gas is not active.

For the latter technique, the dangling bonds are adequately terminated because hydrogen activation seeds in the plasma are used for the termination and thereby it is expected that a high-reliability device can be obtained. However, it is clarified that a high-reliability device cannot always be obtained when the dangling bonds are actually terminated by the latter technique. The inventor of the present invention studied the cause that no high-reliability device can be obtained contrary to expectation. As a result, it is clarified that the cause lies in the fact that, because the latter technique generates plasma, the plasma damages the oxide film and the oxide film/silicon interface and thereby defects and dangling bonds are newly produced.

After all, there is no technique for adequately terminating the dangling bonds without damaging the oxide film and the oxide film/silicon interface at present.

The present invention is made to solve the problem of the prior art and its object is to provide a semiconductor device manufacturing method for realizing the manufacturing of a semiconductor device having a high-reliability interface between an insulating film and semiconductor (e.g. an oxide film/silicon interface).

### (Semiconductor device)

The prior art is described below by using an oxide film as an insulating film and silicon as semiconductor.

The sintering method is hitherto known as one of the techniques for terminating dangling bonds on an oxide film/silicon interface. This is a method for terminating dangling bonds on an oxide film/silicon interface by hydrogen by forming an oxide film or an oxide film, electrode, and wiring on a silicon substrate and thereafter bringing a mixed gas of hydrogen gas and inert gas into contact with the heated silicon substrate.

A technique is also known for terminating dangling bonds by hydrogen by transforming hydrogen gas or a mixed gas of an inert gas and hydrogen gas into plasma and bringing hydrogen ions and hydrogen seeds in the plasma into contact with an oxide film/silicon substrate.

For the former technique, however, termination of the dangling bonds on the oxide film/silicon interface is insufficient and therefore not high-reliability device can be manufactured because the introduced gas is not active.

For the latter technique, the dangling bonds are adequately terminated because hydrogen activation seeds in the plasma are used for the termination and thereby it is expected that a high-reliability device can be obtained. However, it is clarified that a high-reliability device cannot always be obtained when the dangling bonds are actually terminated by the latter technique. The inventor of the present invention studied the cause that no high-reliability device can be obtained contrary to expectation. As a result, it is clarified that the cause lies in the fact that, because the latter technique generates plasma, the plasma damages the oxide film and the oxide film/silicon interface and thereby defects and dangling bonds are newly produced.

After all, there is no technique for adequately terminating the dangling bonds without damaging the oxide film and the oxide film/silicon interface at present or no semiconductor device with a low interfacial level of an oxide film/semiconductor interface and a high reliability is realized.

The present invention is made to solve the above problem of the prior art and its object is to provide a semiconductor device having a high-reliability interface between an insulating film and semiconductor (e.g. oxide film/silicon interface).

### Disclosure of the Invention

### (Inventions in claims 1 through 7)

A gist of the present invention lies in an apparatus for foming oxide film comprising at least;
a furnace tube having an aperture which can be opened or closed to bring in or out an object to be treated, hydrogen gas introduction port for introducing gas into the tube, and an oxygen gas introduction port for introducing oxygen gas into the tube;
furnace tube heating means for heating the inside of the furnace tube;
a hydrogen gas introduction tube connected through the hydrogen gas introduction port;
an oxygen gas introduction tube connected through the oxygen gas introduction port; and
heating means for heating the hydrogen gas introduction tube; wherein
at least the inner surface of the hydrogen gas introduction tube is made of nickel or a material containing nickel.

Another gist of the present invention lies in an apparatus for foming oxide film comprising at least:
a furnace tube having an aperture which can be opened or closed to bring in or out an object to be treated and a gas introduction port for introducing gas into the tube;
furnace tube heating means for heating the inside of the furnace tube;
a gas introduction tube connected through the gas introduction port and having a plurality of branch tubes at the gas source side; and
heating means for heating the branch tubes for introducing hydrogen gas or a gas containing hydrogen gas; wherein
at least the inner surface of some or all of the branch tubes for introducing hydrogen gas or a gas containing hydrogen gas is made of nickel or a material containing nickel.

### Functions of the inventions in claims 1 through 7

By bringing hydrogen or a gas containing hydrogen introduced into a furnace tube into contact with nickel or an alloy containing nickel heated up to a temperature of 300°C or higher, hydrogen activation seeds are produced. By mixing the hydrogen activation seeds with oxygen gas or a gas containing oxygen introduced into the furnace tube, the hydrogen activation seeds react on the oxygen to produce water without combustion. Therefore, no particle is produced because the tip of a hydrogen introduction quartz tube is not melted.

### Embodiment examples of the inventions in claims 1 through 7

### (Claim 1)

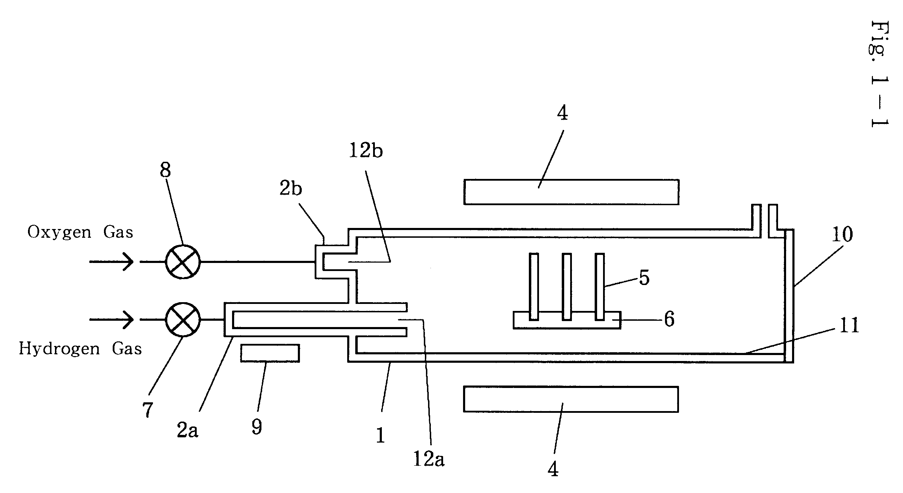

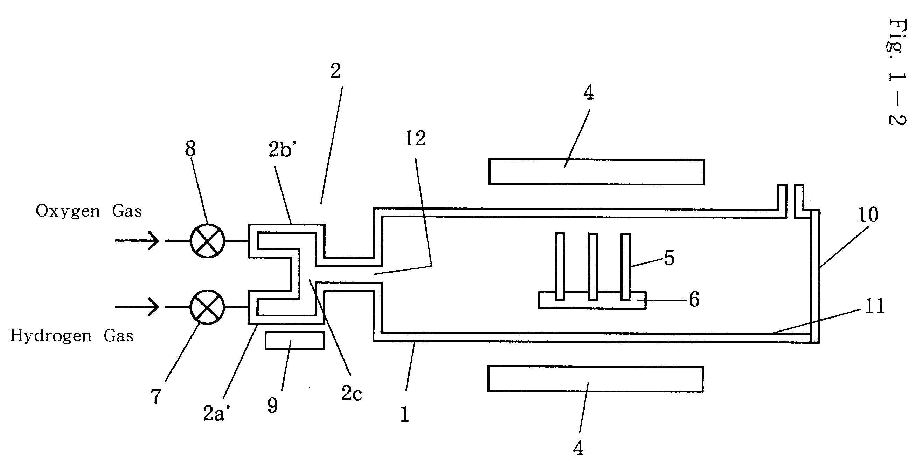

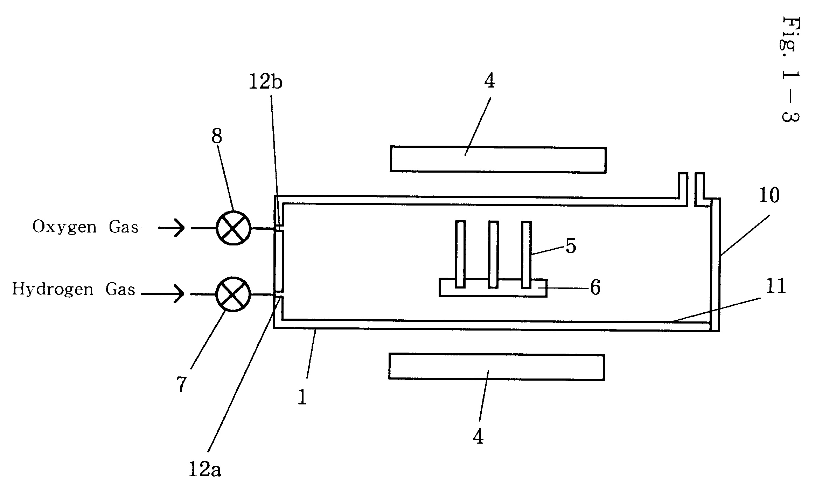

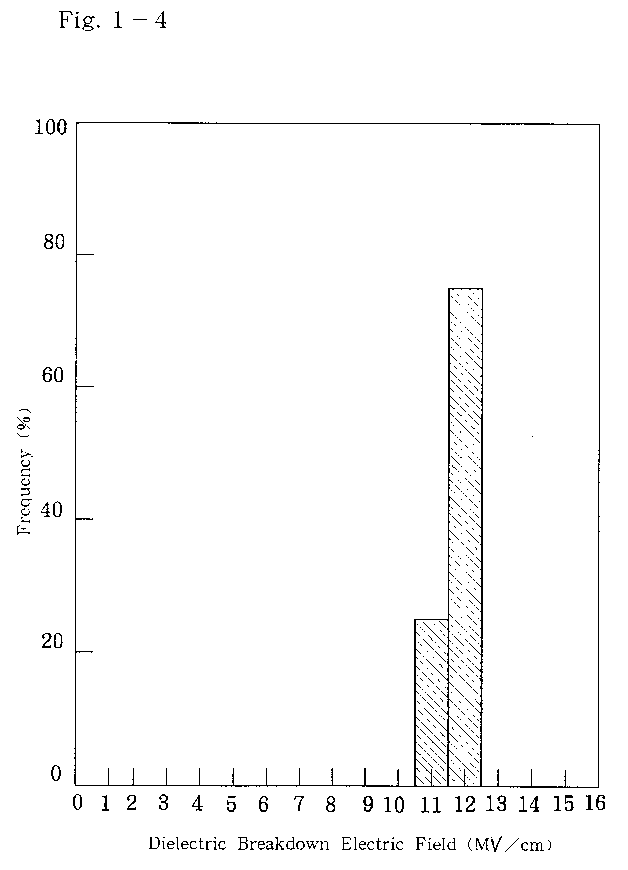

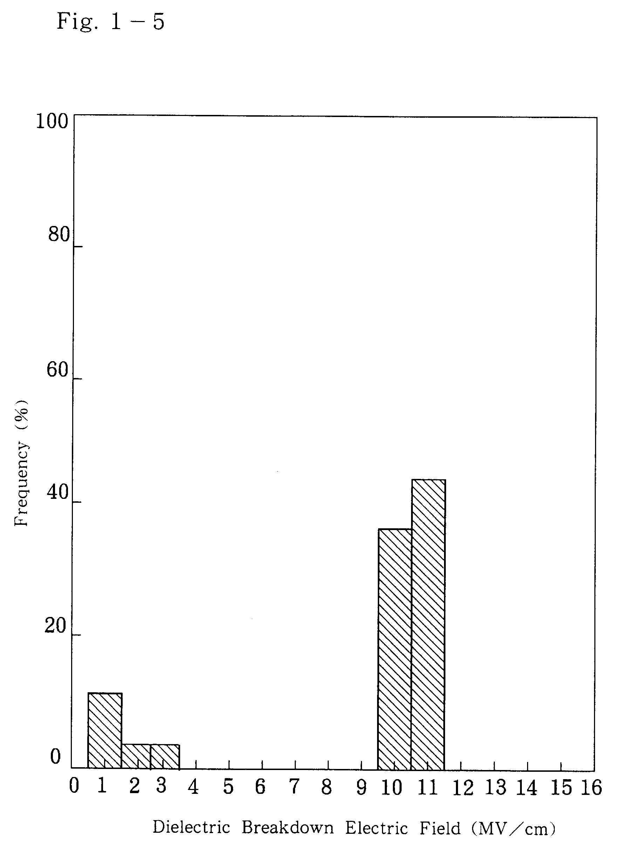

As shown in Fig. 1-1, for example, a hydrogen gas introduction tube 2a is connected to a furnace tube 1 through a hydrogen gas introduction port 12a and heating means 9 is arranged so that the heating means 9 can heat the hydrogen gas introduction tube 2a. In this case, it is necessary that the inner surface of the hydrogen gas introduction tube 2a is made of nickel or a material containing nickel.

An oxygen introduction tube 3 is connected to the furnace tube 1 through an oxygen introduction port 12b.

In this case, by heating the inside of the hydrogen gas introduction tube 2a to 300°C or higher by the heating means and introducing hydrogen gas into the hydrogen gas introduction tube 2a from a hydrogen gas source, hydrogen activation seeds are produced from the hydrogen gas contacting the inner surface of the hydrogen gas introduction tube 2a. This is probably because the nickel constituting the hydrogen gas introduction tube 2a or the material containing nickel constituting the tube 2a serves as a catalyst. The hydrogen activation seeds produced in the above manner do not damage an object to be treated because they do not cause plasma.

The hydrogen activation seeds react on oxygen introduced into the furnace tube 1 from the oxygen gas introduction tube 2b through the oxygen gas introduction port 12b, producing water. This reaction does not melt the furnace tube 1 or produce particles because it does not cause combustion. It is preferable to set the downstream end of the hydrogen gas introduction tube 2a separately from the side wall of the furnace tube 1.

### (Claim 2)

As shown in Fig. 1-2, a gas introduction tube 2 having branch tubes 2a' and 2b' is connected to a furnace tube 1 through a gas introduction port 12. The branch tube 2a' is connected to a hydrogen gas source and the branch tube 2b' is connected to an oxygen gas source.

A part or the whole of the inner surface of the branch tube 2a' is made of nickel or a material containing nickel. Heating means 9 is arranged so that the heating means 9 can heat the branch tube 2a'.

In Figs. 1-1 and 1-2, the introduction tube 2 is used. However, it is also possible to use nickel or a material containing nickel for the inner surface of the furnace tube 1 without using the introduction tube as shown in Fig. 1-3.

In this case, the heating means shown in Figs. 1-1 and 1-2 is unnecessary and heating can be made by the furnace tube heating means 4. Therefore, it is possible to produce hydrogen activation seeds in the furnace tube 1. It is enough to use nickel or a material containing nickel only for a part of the inner surface at the upstream side of the position where the object 5 to be treated is set. However, it is also possible to use the material for the remaining part of the inner surface.

For the above embodiment example, nickel or a material containing nickel is used for the inner surface of an introduction tube or furnace tube to constitute hydrogen activation seed producing means. However, it is also possible to use a constitution other than the above. For example, it is possible to constitute the hydrogen activation seed producing means by setting a vessel filled with nickel (e.g. filamentary nickel, network nickel, or sponge nickel) between the hydrogen gas source and the furnace tube. By passing hydrogen gas or a gas containing hydrogen gas through the vessel and heating the vessel to 300°C or higher, hydrogen activation seeds can be obtained and they can be introduced into the furnace tube.

The following is the description of nickel or a material containing nickel.

Ni-group alloys, for example, are preferable as the material containing nickel. Among the Ni-group alloys, Ni-Mo-based alloys and Ni-W-based alloys are further preferable. More specifically, HASUTEROI (trademark) is listed.

It is also possible to use, for example, stainless steel whose surface is electropolished to a surface roughness of 1 µm or less as another material containing nickel. In this case, it is more preferable to use stainless steel on whose surface a passive-state film is formed as the result of thermal treatment in an oxidizing atmosphere with an impurity concentration of 10 ppb or less. It is furthermore preferable to use stainless steel on whose surface a passive-state film is formed as the result of thermal treatment in an oxidizing atmosphere and deoxidization in a hydrogen atmosphere (separately proposed in Japanese Patent Application No. Hei 3-212592). The surfaces of these passive-state films mainly contain chrome oxide. The surfaces are superior in corrosion resistance and they adsorb only very small quantity of water. Therefore, it is possible to almost prevent impurities from mixing with gas. The surface roughness of the passive-state film of 0.5 µm or less is preferable and that of 0.1 µm or less is more preferable. Though the passive-state film mainly contains chrome oxide, it also contains nickel oxide. Therefore, it is estimated that the nickel in the nickel oxide serves as a catalyst and thereby hydrogen activation seeds are produced from the hydrogen contacting the passive-state film surface.

### (Inventions in claims 8 through 19)

The heat treatment apparatus of the present invention comprise at least:
a furnace tube having an aperture which can be opened or closed to bring in or out an object to be treated and a gas introduction port for introducing gas into the tube;
furnace tube heating means for heating the inside of the furnace tube; and
hydrogen activation seed producing means for producing hydrogen activation seeds from hydrogen gas or a gas containing hydrogen without causing plasma at the upstream side of the position of an object to be treated set in the furnace tube.

### Functions of the inventions in claims 8 through 19

For the present invention, because hydrogen activation seed producing means for producing hydrogen activation seeds without causing plasma is provided at the upstream side of the position of an object to be treated set in a furnace tube, hydrogen activation seeds are produced by introducing hydrogen gas or a gas containing hydrogen into the hydrogen activation seed producing means.

When, for example, a silicon substrate with an oxide film formed on it is arranged in the furnace tube as an object to be treated, hydrogen activation seeds diffuse in the oxide film and terminate dangling bonds in the oxide film and on an oxide film/silicon interface. Therefore, a high-reliability oxide film is obtained.

### Embodiment examples of the inventions in claims 8 through 19

Embodiment examples of the present invention are described below. It is one of the features of the present invention to use hydrogen activation seed producing means for producing hydrogen activation seeds from hydrogen gas or a gas containing hydrogen without causing plasma. The hydrogen activation seed producing means is constituted as shown below.

### (Claim 9)

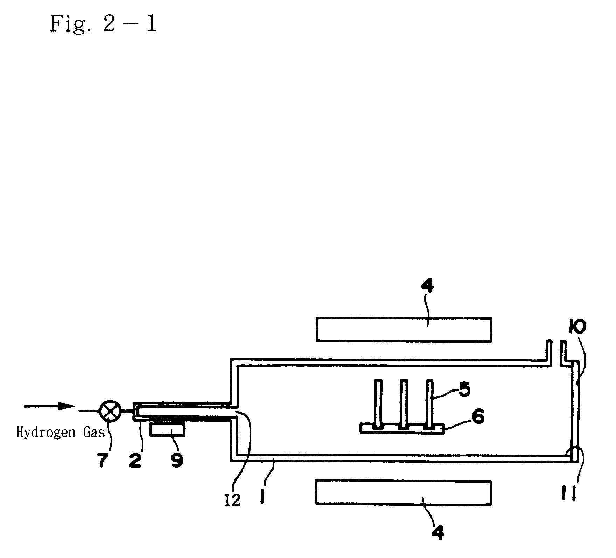

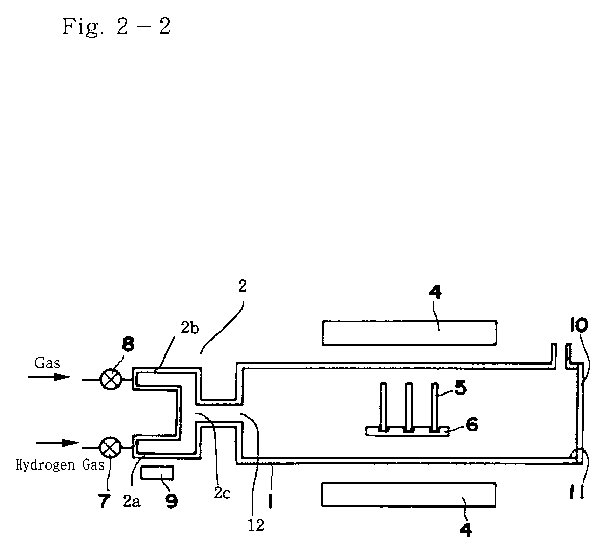

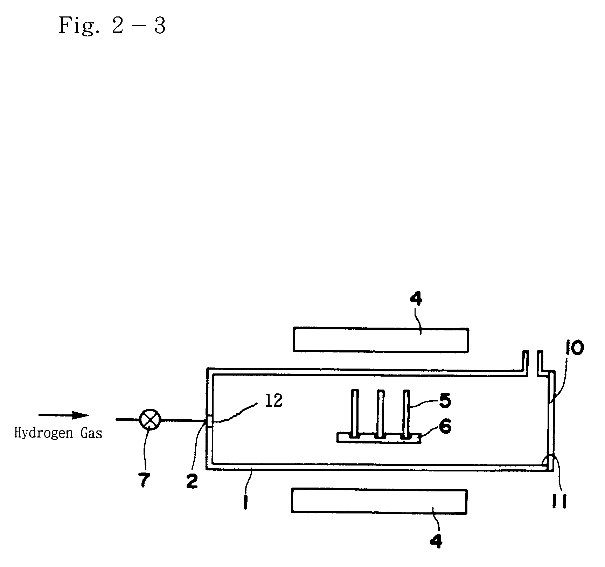

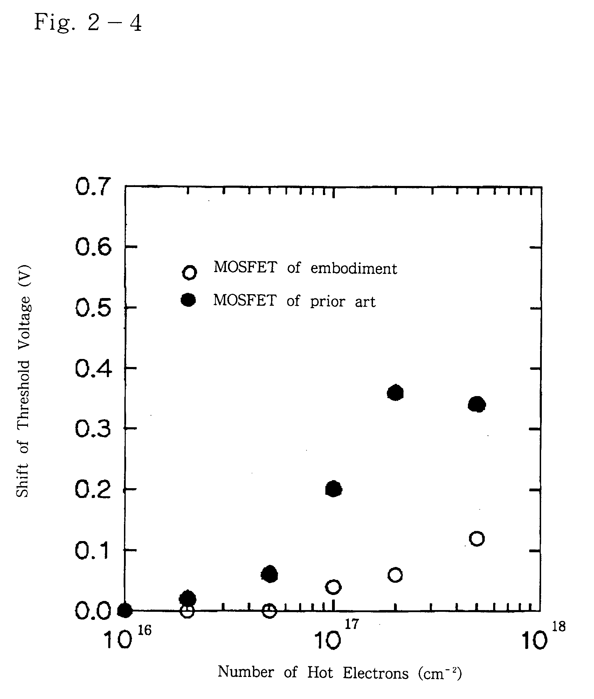

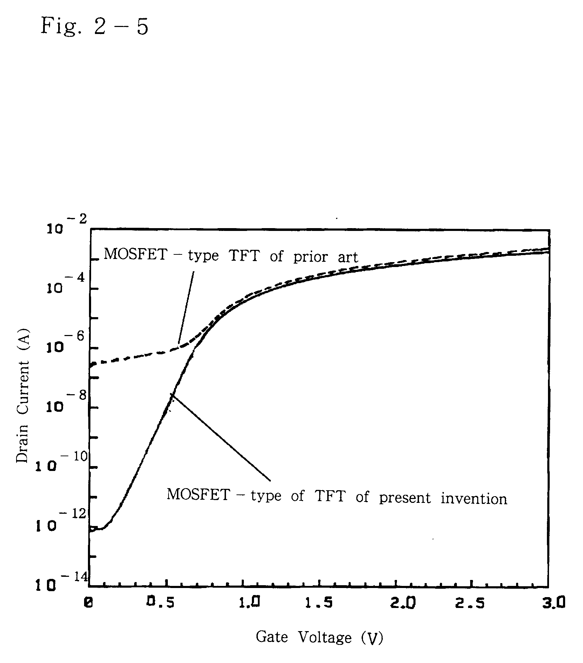

For example, as shown in Fig. 2-1, a gas introduction tube 2 is connected to a furnace tube 1 through a gas introduction port 12 and heating means 9 is arranged so that the heating means 9 can heat the gas introduction tube 2. In this case, it is necessary to use nickel or a material containing nickel for the inner surface of the gas introduction tube 2.

In this case, by heating the inside of the gas introduction tube 2 to 300°C or higher by the heating means and introducing hydrogen gas into the gas introduction tube 2 from a hydrogen gas source, hydrogen activation seeds are produced from the hydrogen gas contacting the inner surface of the gas introduction tube 2. This is probably because nickel itself constituting the gas introduction tube 2 or the nickel in the material containing nickel constituting the tube 2 serves as a catalyst at a temperature of 300°C or higher. However, thus produced hydrogen activation seeds do not damage an object to be treated because they do not cause plasma.

### (Claim 10)

To introduce hydrogen gas into a furnace tube together with other gas (e.g. inert gas such as Ar or the like), a gas introduction tube 2 having branch tubes 2a and 2b is connected to a furnace tube 1 through a gas introduction port 12 as shown in Fig. 2-2. The branch tube 2a is connected to a hydrogen gas source. The embodiment shown in Fig. 2-2 has two branch tubes. However, it is possible to use more than two branch tubes according to necessity.

It is necessary to use nickel or a material containing nickel for a part or the whole of the inner surface of the introduction tube 2. In the case of the embodiment shown in Fig. 2-2, the inner surface of the branch tube 2a is made of nickel or a material containing nickel (claim 11). The heating means 9 is arranged so that it can heat the branch tube 2a (claim 12). Of curse, it is possible to arrange the heating means 9 so that it can heat a portion where the branch tubes 2a and 2b meet (this portion serves as a portion 2c for mixing gases sent from the branch tubes 2a and 2b).

### (Claim 14)

Figs. 2-1 and 2-2 show examples using the introduction tube 2. However, it is also possible to use nickel or a material containing nickel for the inner surface of a furnace tube 1 without using the introduction tube 2 as shown in Fig. 2-3.

In this case, it is unnecessary to use the heating means shown in Figs. 2-1 and 2-2 and it is possible to carry out heating by the furnace tube heating means 4. Therefore, it is possible to produce hydrogen activation seeds in the furnace tube 1. It is enough to use nickel or a material containing nickel only for the upstream side of the position where an object 5 to be treated is set. However, it is also possible to use the above material for the remaining part of the inner surface.

For the above embodiment example, nickel or a material containing nickel is used for the inner surface of an introduction tube or furnace tube to constitute hydrogen activation seed producing means. However, it is also possible to use a constitution other than the above. For example, it is possible to constitute the hydrogen activation seed producing means by setting a vessel filled with nickel (e.g. filamentary nickel, network nickel, or sponge nickel) between the hydrogen gas source and the furnace tube. By passing hydrogen gas or a gas containing hydrogen gas through the vessel and heating the vessel to 300°C or higher, hydrogen activation seeds can be obtained and they can be introduced into the furnace tube.

The following is the description of nickel or materials containing nickel.

Ni-group alloys, for example, are preferable as the material containing nickel. Among the Ni-group alloys, Ni-Mo-based alloys and Ni-W-based alloys are further preferable. More specifically, HASUTEROI (trademark) is listed.

It is also possible to use, for example, stainless steel whose surface is electropolished to a surface roughness of 1 µm or less as another material containing nickel. In this case, it is more preferable to use stainless steel on whose surface a passive-state film is formed as the result of thermal treatment in an oxidizing atmosphere with an impurity concentration of 10 ppb or less. It is furthermore preferable to use stainless steel on whose surface a passive-state film is formed as the result of thermal treatment in an oxidizing atmosphere and deoxidization in a hydrogen atmosphere (separately proposed in Japanese Patent Application No. Hei 3-212592). The surfaces of these passive-state films mainly contain chrome oxide. The surfaces are superior in corrosion resistance and they adsorb only very small quantity of water. Therefore, it is possible to almost prevent impurities from mixing with gas. The surface roughness of the passive-state film of 0.5 µm or less is preferable and that of 0.1 µm or less is more preferable. Though the passive-state film mainly contains chrome oxide, it also contains nickel oxide. Therefore, it is estimated that the nickel in the nickel oxide serves as a catalyst and thereby hydrogen activation seeds are produced from the hydrogen contacting the passive-state film surface.

### (Inventions in claims 20 through 31)

The semiconductor device manufacturing methods of the present invention are characterized by bringing hydrogen activation seeds without causing plasma into contact with an insulating film in a method for fabricating a semiconductor device having an insulating film/semiconductor interface.

A semiconductor manufacturing method is characterized by bringing hydrogen or a gas containing hydrogen brought into contact with nickel or a material containing nickel heated to a temperature of 300°C or higher into contact with a substrate having an insulating film on at least part of the substrate.

### Functions of the inventions in claims 20 through 31

For the semiconductor device manufacturing methods of the present invention, hydrogen activation seeds without causing plasma (e.g. hydrogen activation seeds produced by bringing them into contact with nickel or a material containing nickel heated to a temperature of 300°C or higher) are brought into contact with an insulating film of a semiconductor device having an insulating film/semiconductor interface (e.g. silicon oxide film/silicon interface). When hydrogen activation seeds contact the insulating film, they diffuse in the insulating film and terminate dangling bonds in the insulating film and on the insulating film/semiconductor interface without damaging them. Therefore, a high-reliability insulating film and accordingly a high-reliability semiconductor device are obtained.

### Embodiment examples of the inventions in claims 20 through 31

Embodiment examples of the present invention are described below.

### (Hydrogen activation seed producing means)

It is one of the features of the present invention to produce hydrogen activation seeds from hydrogen gas or a gas containing hydrogen without causing plasma and terminate dangling bonds using the hydrogen activation seeds. The means for producing the hydrogen activation seeds (hydrogen activation seed producing means) can be constituted as shown below.

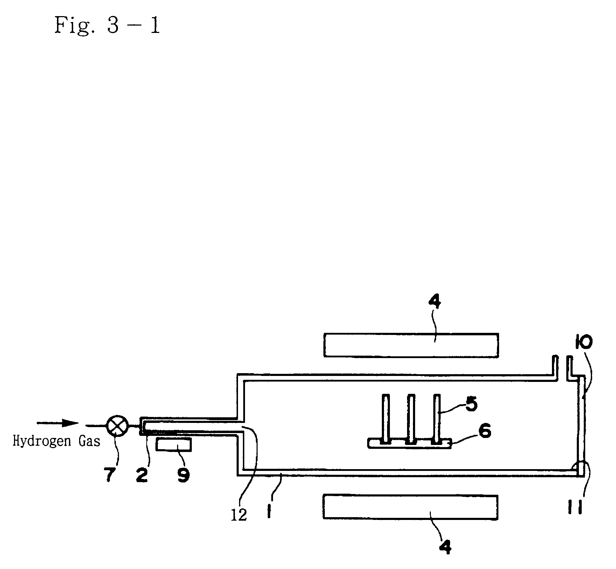

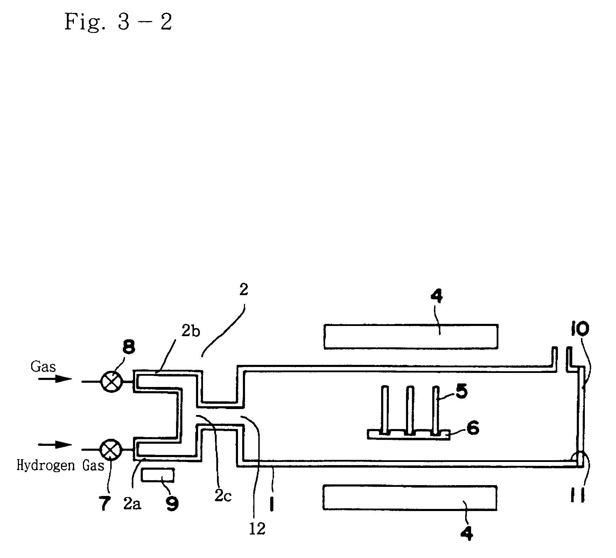

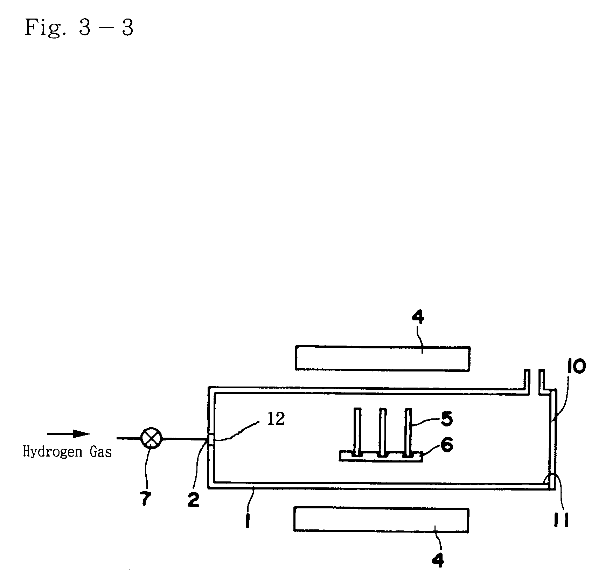

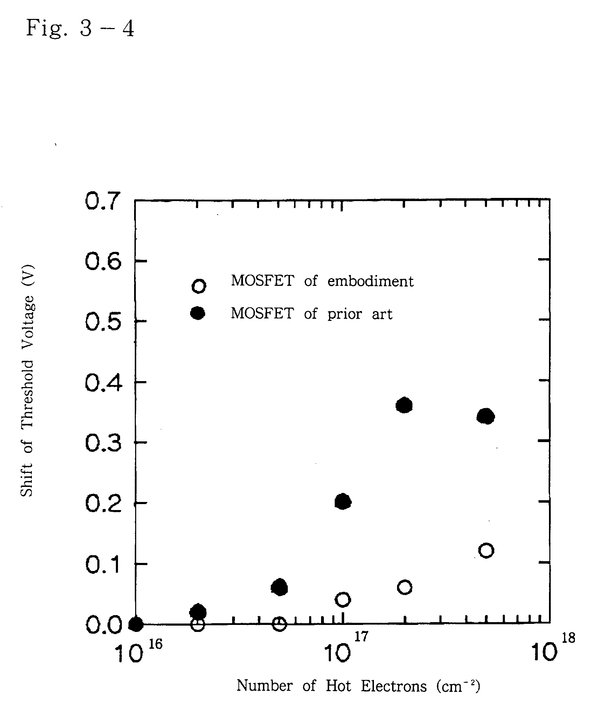

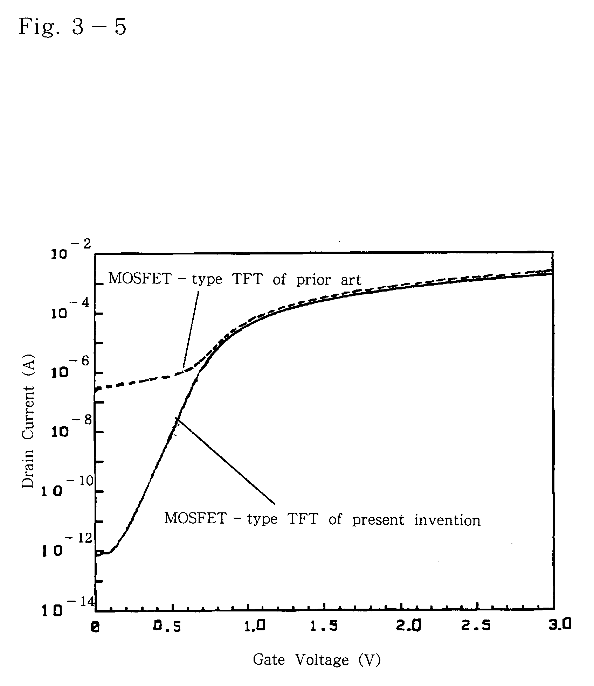

For example, as shown in Fig. 3-1, a gas introduction tube 2 is connected to a furnace tube 1 through a gas introduction port 12 and heating means 9 is arranged so that the heating means 9 can heat the gas introduction tube 2. In this case, it is necessary to use nickel or a material containing nickel for the inner surface of the gas introduction tube 2.

In this case, by heating the inside of the gas introduction tube 2 to 300°C or higher by the heating means and introducing hydrogen gas into the gas introduction tube 2 from a hydrogen gas source, hydrogen activation seeds are produced from the hydrogen gas contacting the inner surface of the gas introduction tube 2. This is probably because nickel itself constituting the gas introduction tube 2 or the nickel in the material containing nickel constituting the tube 2 serves as a catalyst at a temperature of 300°C or higher. However, thus produced hydrogen activation seeds do not damage an object to be treated because they do not cause plasma.

To introduce hydrogen gas into a furnace tube together with other gas (e.g. inert gas such as Ar or the like), a gas introduction tube 2 having branch tubes 2a and 2b is connected to a furnace tube 1 through a gas introduction port 12 as shown in Fig. 3-2. The branch tube 2a is connected to a hydrogen gas source. The example shown in Fig. 3-2 has two branch tubes. However, it is possible to use more than two branch tubes according to necessity.

It is necessary to use nickel or a material containing nickel for a part or the whole of the inner surface of the introduction tube 2. In the case of the embodiment shown in Fig. 3-2, the inner surface of the branch tube 2a is made of nickel or a material containing nickel. The heating means 9 is arranged so that it can heat the branch tube 2a. Of course, it is possible to arrange the heating means 9 so that it can heat a portion where the branch tubes 2a and 2b meet (this portion serves as a portion 2c for mixing gases sent from the branch tubes 2a and 2b).

Figs. 3-1 and 3-2 show examples using the introduction tube 2. However, it is also possible to use nickel or a material containing nickel for the inner surface of a furnace tube 1 without using the introduction tube 2 as shown in Fig. 2-3.

In this case, it is unnecessary to use the heating means shown in Figs. 3-1 and 3-2 and it is possible to carry out heating by the furnace tube heating means 4. Therefore, it is possible to produce hydrogen activation seeds in the furnace tube 1. It is enough to use nickel or a material containing nickel only for the upstream side of the position where an object 5 to be treated is set. However, it is also possible to use the above material for the remaining part of the inner surface.

For the above embodiment example, nickel or a material containing nickel is used for the inner surface of an introduction tube or furnace tube to constitute hydrogen activation seed producing means. However, it is also possible to use a constitution other than the above. For example, it is possible to constitute the hydrogen activation seed producing means by setting a vessel filled with nickel (e.g. filamentary nickel, network nickel, or sponge nickel) between the hydrogen gas source and the furnace tube. By passing hydrogen gas or a gas containing hydrogen gas through the vessel and heating the vessel to 300°C or higher, hydrogen activation seeds can be obtained and they can be introduced into the furnace tube.

Moreover, when a wiring portion of a semiconductor device is formed with nickel or a nickel alloy, hydrogen activation seeds are produced by heating the wiring portion to 300°C or higher and bringing hydrogen gas or a gas containing hydrogen into contact with the portion.

### (Nickel and materials containing nickel)

The following is the description of nickel or materials containing nickel.

Ni-group alloys, for example, are preferable as the material containing nickel. Among the Ni-group alloys, Ni-Mo-based alloys and Ni-W-based alloys are further preferable. More specifically, HASUTEROI (trademark) is listed.

It is also possible to use, for example, stainless steel whose surface is electropolished to a surface roughness of 1 µm or less as another material containing nickel. In this case, it is more preferable to use stainless steel on whose surface a passive-state film is formed as the result of thermal treatment in an oxidizing atmosphere with an impurity concentration of 10 ppb or less. It is furthermore preferable to use stainless steel on whose surface a passive-state film is formed as the result of thermal treatment in an oxidizing atmosphere and deoxidization in a hydrogen atmosphere (separately proposed in Japanese Patent Application No. Hei 3-212592) is formed. The surfaces of these passive-state films mainly contain chrome oxide. The surfaces are superior in corrosion resistance and they adsorb only very small quantity of water. Therefore, it is possible to almost prevent impurities from mixing with gas. The surface roughness of the passive-state film of 0.5 µm or less is preferable and that of 0.1 µm or less is more preferable. Though the passive-state film mainly contains chrome oxide, it also contains nickel oxide. Therefore, it is estimated that the nickel in the nickel oxide serves as a catalyst and thereby hydrogen activation seeds are produced from the hydrogen contacting the passive-state film surface.

### (Insulating film and semiconductor)

As the semiconductor in the present invention, a semiconductor wafer, an insulating substrate, or a semiconductor layer formed on the semiconductor wafer is listed.

As the semiconductor layer, a compound semiconductor layer made of silicon, germanium, or GaAs is listed.

Any one of amorphous, polycrystalline, and single-crystalline states is permitted as the crystalline state of semiconductor.

An oxide film and nitride film are listed as the insulating film. The insulating film can use any one of the films formed by heating (e.g. thermal oxide film), formed by deposition (e.g. deposited oxide film), and formed by any other method.

### (Temperature of nickel or material containing nickel)

The temperature of nickel or a material containing nickel should be kept at 300°C or higher. In the case of a temperature lower than 300°C, hydrogen activation seeds are not adequately produced. Particularly, a temperature between 300 and 450°C is preferable and a temperature between 300 and 400°C is more preferable. In the case of a temperature exceeding 450°C, hydrogen activation seeds are more produced. However, when no passive-state film is formed on the surface of nickel or a material containing nickel, impurities are emitted from the surface and they may be mixed into gas.

### (Treatment temperature)

For the present invention, a temperature between 20 and 1,200°C is preferable, a temperature between 20 and 600°C is more preferable, and a temperature between 20 and 450°C is furthermore preferable as a substrate temperature when a gas containing hydrogen activation seeds is brought into contact with a substrate having an insulating film.

### (Gas)

For the present invention, a gas to be brought into contact with nickel or a material containing nickel uses hydrogen gas or a gas containing hydrogen. It is possible to use, for example, a mixed gas of hydrogen gas and an inert gas (e.g. Ar gas or nitrogen gas or the like) as the gas containing hydrogen. However, the gas flow rate is not restricted.

### (Inventions in claims 32 through 39)

The semiconductor devices of the present invention have an insulating film sintered by hydrogen activation seeds free from plasma.

### Functions of the inventions in claim 32 through 39

For the semiconductor devices of the present invention, the insulating film of the semiconductor device having an insulating film/semiconductor interface (e.g. silicon oxide film/silicon interface) is formed by bringing hydrogen activation seeds free from plasma (e.g. hydrogen activation seeds produced by bringing them into contact with nickel or a material containing nickel heated to 300°C or higher) into contact with the film. When hydrogen activation seeds contact the insulating film, they diffuse in the film and terminates dangling bonds in the insulating film and on the insulating film/semiconductor interface without damaging the bonds. Therefore, a high-reliability insulating film and resultingly a high-reliability semiconductor device are obtained.

### Embodiment examples of the inventions in claims 32 through 39

Embodiment examples of the present invention are described below.

### (Hydrogen activation seed producing means)

It is one of the features of the present invention to produce hydrogen activation seeds without causing plasma and terminate dangling bonds using the hydrogen activation seeds. The means for producing the hydrogen activation seeds (Hydrogen activation producing means) can be constituted as shown below.

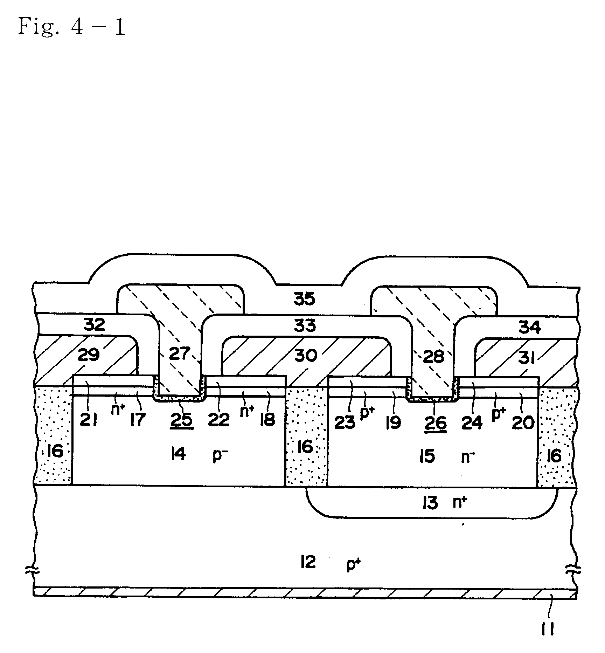

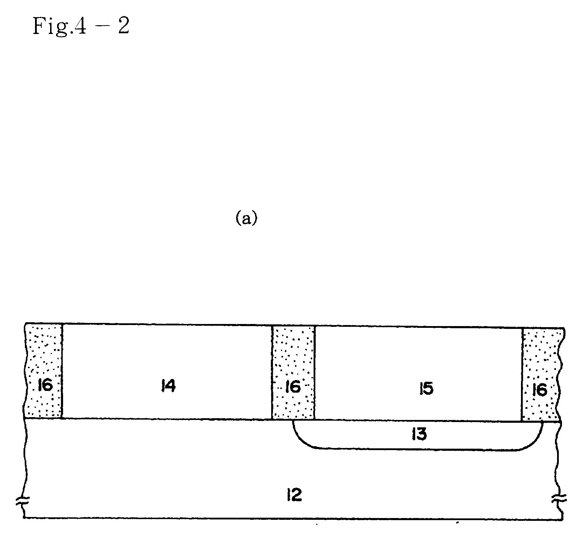

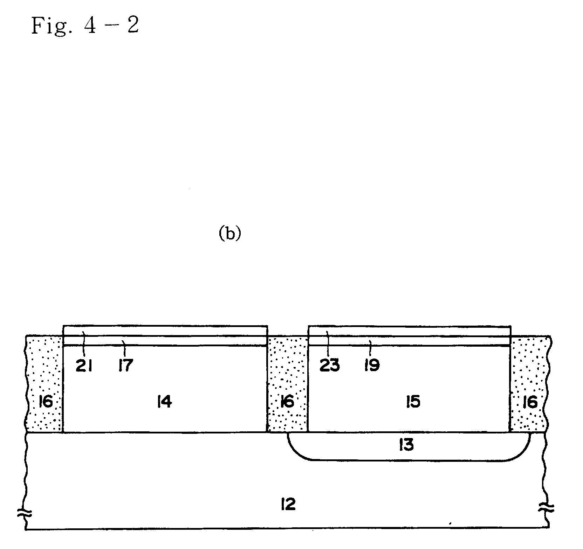

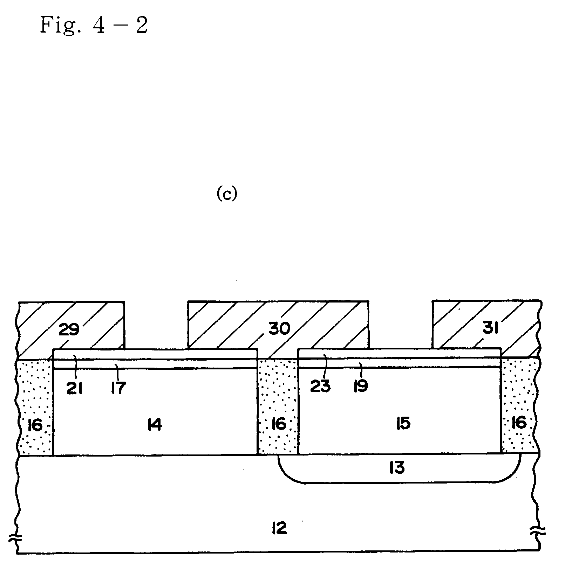

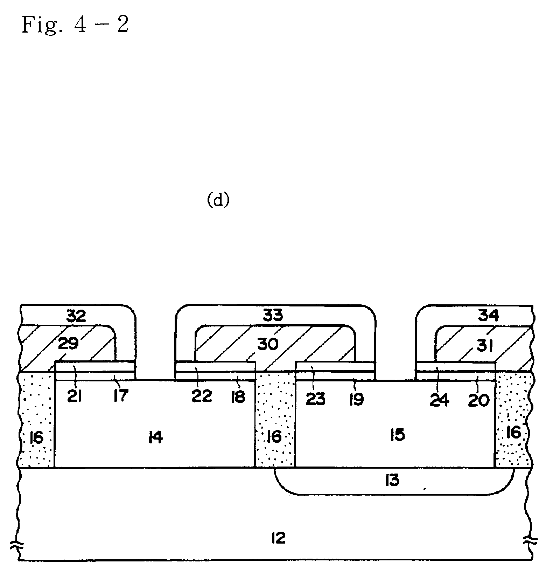

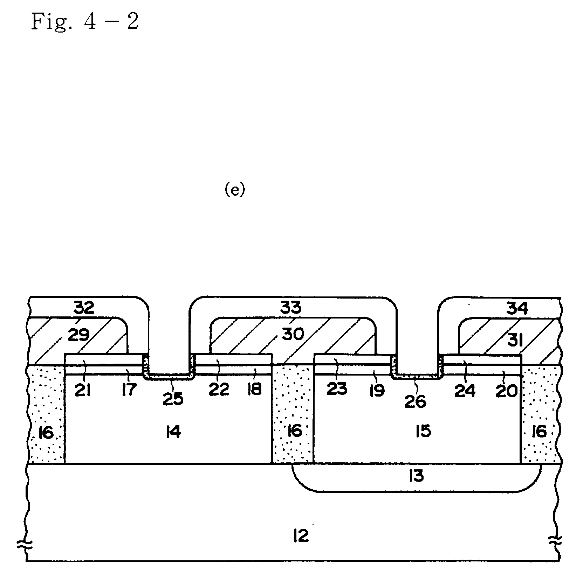

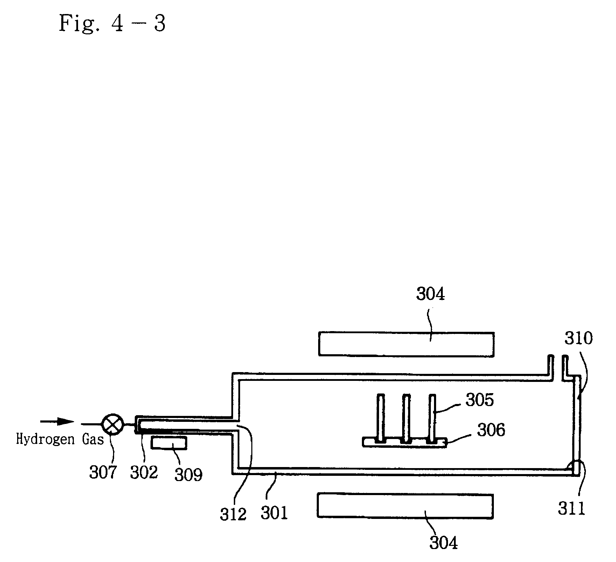

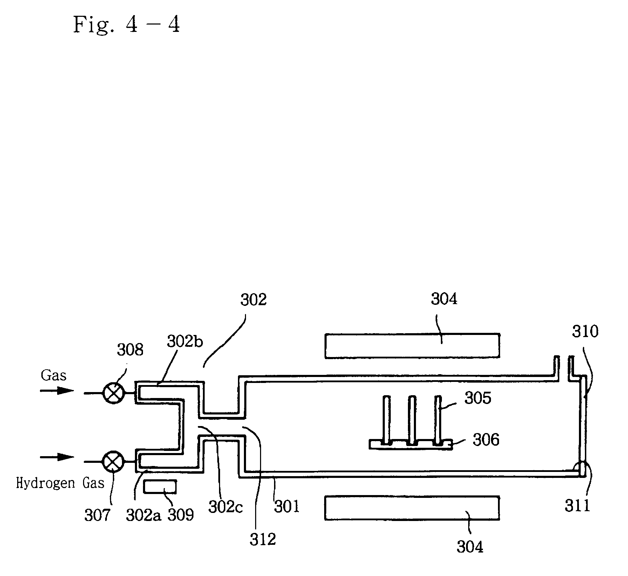

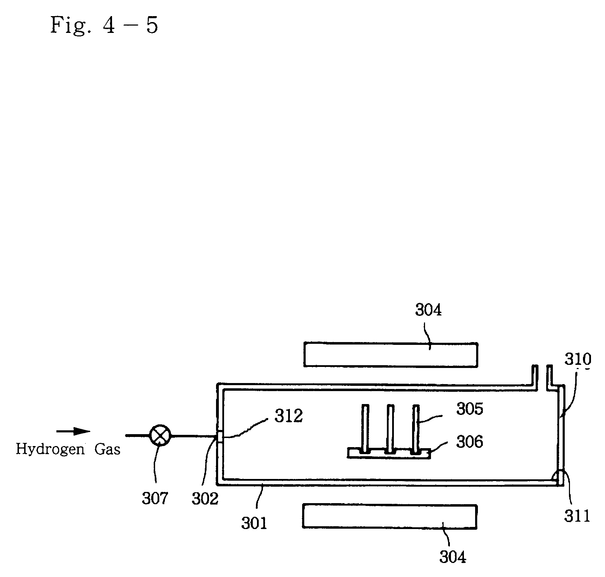

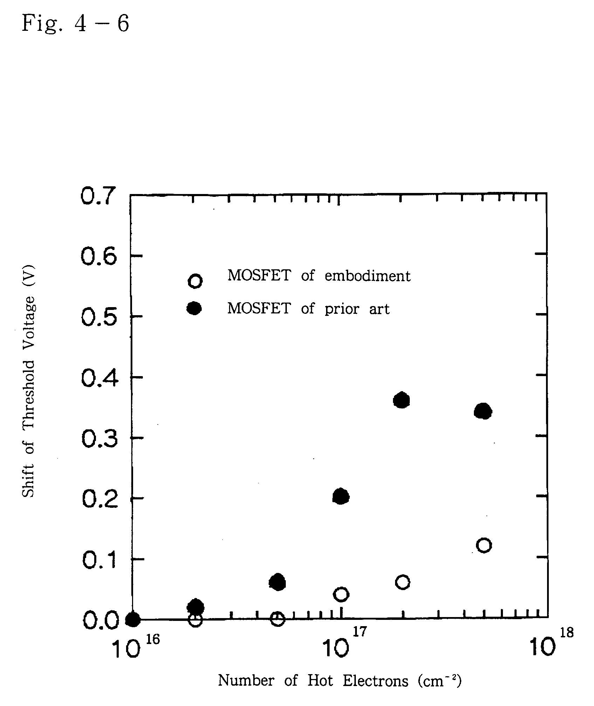

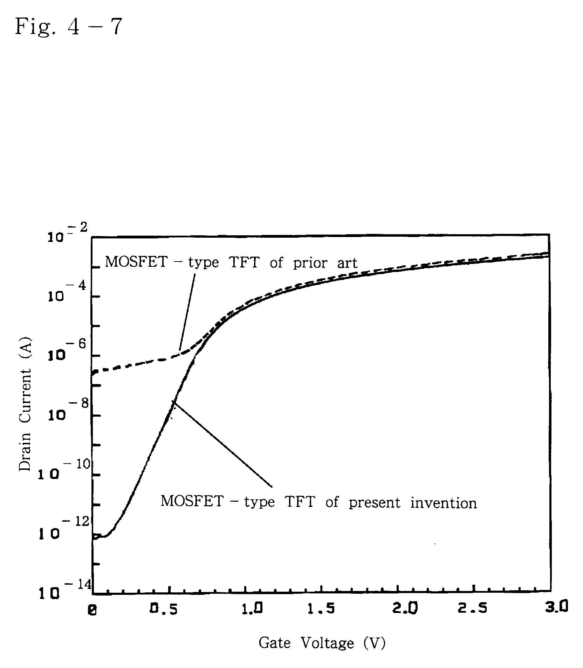

For example, as shown in Fig. 4-3, a gas introduction tube 302 is connected to a furnace tube 301 through a gas introduction port 312 and heating means 309 is arranged so that the heating means 309 can heat the gas introduction tube 302. In this case, it is necessary to use nickel or a material containing nickel for the inner surface of the gas introduction tube 302.

In this case, by heating the inside of the gas introduction tube 302 to 300°C or higher by the heating means and introducing hydrogen gas into the gas introduction tube 302 from a hydrogen gas source, hydrogen activation seeds are produced from the hydrogen gas contacting the inner surface of the gas introduction tube 302. This is probably because nickel itself constituting the gas introduction tube 302 or the nickel in the material containing nickel constituting the tube 302 serves as a catalyst at a temperature of 300°C or higher. However, thus produced hydrogen activation seeds do not damage an object to be treated because they do not cause plasma.

To introduce hydrogen gas into a furnace tube together with other gas (e.g. inert gas such as Ar or the like), a gas introduction tube 302 having branch tubes 302a and 302b is connected to a furnace tube 301 through a gas introduction port 312 as shown in Fig. 4-4. The branch tube 302a is connected to a hydrogen gas source. The embodiment shown in Fig. 4-4 has two branch tubes. However, it is possible to use more than two branch tubes according to necessity.

It is necessary to use nickel or a material containing nickel for a part or the whole of the inner surface of the introduction tube 302. In the case of the example shown in Fig. 4-4, the inner surface of the branch tube 302a is made of nickel or a material containing nickel. The heating means 309 is arranged so that it can heat the branch tube 302a. Of curse, it is possible to arrange the heating means 309 so that it can heat a portion where the branch tubes 302a and 302b meet (this portion serves as a portion 302c for mixing gases sent from the branch tubes 302a and 302b).

Figs. 4-3 and 4-4 show embodiments using the introduction tube 302. However, it is also possible to use nickel or a material containing nickel for the inner surface of a furnace tube 301 without using the introduction tube 302 as shown in Fig. 4-5.

In this case, it is unnecessary to use the heating means shown in Figs. 4-3 and 4-4 and it is possible to carry out heating by the furnace tube heating means 4. Therefore, it is possible to produce hydrogen activation seeds in the furnace tube 301. It is enough to use nickel or a material containing nickel only for the upstream side of the position where the substrate 305 on which a semiconductor device serving as an object to be treated is set is arranged. However, it is also possible to use the above material for the remaining part of the inner surface.

For the above embodiment example, nickel or a material containing nickel is used for the inner surface of an introduction tube or furnace tube to constitute hydrogen activation seed producing means. However, it is also possible to use a constitution other than the above. For example, it is possible to constitute the hydrogen activation seed producing means by setting a vessel filled with nickel (e.g. filamentary nickel, network nickel, or sponge nickel) between the hydrogen gas source and the furnace tube. By passing hydrogen gas or a gas containing hydrogen gas through the vessel and heating the vessel to 300°C or higher, hydrogen activation seeds can be obtained and they can be introduced into the furnace tube.

When the wiring portion of a semiconductor device is made of nickel or a nickel alloy, hydrogen activation seeds are produced by heating the wiring portion to 300°C or higher and bringing hydrogen gas or a gas containing hydrogen into contact with the wiring portion.

### (Nickel or material containing nickel)

The following is the description of nickel or materials containing nickel.

Ni-group alloys, for example, are preferable as the material containing nickel. Among the Ni-group alloys, Ni-Mo-based alloys and Ni-W-based alloys are further preferable. More specifically, HASUTEROI (trademark) is listed.

It is also possible to use, for example, stainless steel whose surface is electropolished to a surface roughness of 1 µm or less as another material containing nickel. In this case, it is more preferable to use stainless steel on whose surface a passive-state film is formed as the result of thermal treatment in an oxidizing atmosphere with an impurity concentration of 10 ppb or less. It is furthermore preferable to use stainless steel on whose surface a passive-state film is formed as the result of thermal treatment in an oxidizing atmosphere and deoxidization in a hydrogen atmosphere (separately proposed in Japanese Patent Application No. Hei 3-212592) is formed. The surfaces of these passive-state films mainly contain chrome oxide. The surfaces are superior in corrosion resistance and they adsorb only very small quantity of water. Therefore, it is possible to almost prevent impurities from mixing with gas. The surface roughness of the passive-state film of 0.5 µm or less is preferable and that of 0.1 µm or less is more preferable. Though the passive-state film mainly contains chrome oxide, it also contains nickel oxide. Therefore, it is estimated that the nickel in the nickel oxide serves as a catalyst and thereby hydrogen activation seeds are produced from the hydrogen contacting the passive-state film surface.

### (Insulating film and semiconductor)

As the semiconductor in the present invention, a semiconductor wafer, an insulating substrate, or a semiconductor layer formed on the semiconductor wafer is listed.

As the semiconductor layer, a compound semiconductor layer made of silicon, germanium, or GaAs is listed.

Any one of amorphous, polycrystalline, and singlecrystalline states is permitted as the crystalline state of semiconductor.

An oxide film and nitride film are listed as the insulating film. The insulating film can use any one of the films formed by heating (e.g. thermal oxide film), formed by deposition (e.g. deposited oxide film), and formed by any other method.

### (Temperature of nickel or material containing nickel)

The temperature of nickel or a material containing nickel should be kept at 300°C or higher. In the case of a temperature lower than 300°C, hydrogen activation seeds are not adequately produced. Particularly, a temperature between 300 and 450°C is preferable and a temperature between 300 and 400°C is more preferable. In the case of a temperature exceeding 450°C, hydrogen activation seeds are more produced. However, when no passive-state film is formed on the surface of nickel or a material containing nickel, impurities are emitted from the surface and they may be mixed into gas.

### (Treatment temperature)

For the present invention, a temperature between 20 and 1,200°C is preferable, a temperature between 20 and 600°C is more preferable, and a temperature between 20 and 450°C is furthermore preferable as a substrate temperature when a gas containing hydrogen activation seeds is brought into contact with a substrate having an insulating film.

### (Gas)

For the present invention, a gas to be brought into contact with nickel or a material containing nickel uses hydrogen gas or a gas containing hydrogen. It is possible to use, for example, a mixed gas of hydrogen gas and an inert gas (e.g. Ar gas or nitrogen gas) as the gas containing hydrogen. However, the gas flow rate is not restricted.

### Brief Explanation of the Drawings

### (Claims 1 through 7)

Fig. 1-1 shows a schematic block diagram of the heat treatment apparatus of the embodiment 1-1.
Fig. 1-2 shows a schematic block diagram of the heat treatment apparatus of the embodiment 1-2 of the present invention.
Fig. 1-3 shows a schematic block diagram of the heat treatment apparatus of the embodiment 1-3 of the present invention. Fig. 1-4 is a graph showing the withstand voltage of an oxide film formed by the apparatus of the present invention. Fig. 1-5 is a graph showing the withstand voltage of an oxide film formed by an existing apparatus.

### (Figs. 1-1 through 1-5)

### (Description of references)

1: Furnace tube 2: Gas introduction tube 2a: hydrogen gas introduction tube 2b: Oxygen gas introduction tube 2a': Branch tube 2b': Branch tube 4: Heating source 5: Silicon substrate (Object to be heated) 6: Susceptor 7: Valve 8: Valve 9: Hydrogen gas introduction tube heating means 10: Shutter 11: Aperture 12: Gas introduction port 12a': Hydrogen gas introduction port 12b': Oxygen gas introduction port

### (Claims 8 through 19)

Fig. 2-1 shows a schematic block diagram of the heat treatment apparatus of the embodiment 2-1. Fig. 2-2 shows a schematic block diagram of the heat treatment apparatus of the embodiment 2-2. Fig. 2-3 shows a schematic block diagram of the heat treatment apparatus of the embodiment 2-3. Fig. 2-4 is a graph showing the hot electron resistances of a MOSFET formed by the apparatus of the embodiment 2-1 and a MOSFET formed by an existing apparatus. Fig. 2-5 is a graph showing the sub-threshold characteristic of a MOSFET-type TFT transistor formed by the apparatus of the embodiment 2-1 and that of a MOSFET-type TFT transistor formed by an existing apparatus.

### (Figs. 2-1 through 2-5)

### (Description of references)

1: Furnace tube 2: Gas introduction tube 2a: Branch tube 2b: Branch tube 2c: Mixing portion 4: Furnace tube heating means (Heating source) 5: Silicon substrate 6: Susceptor 7: Valve 9: Heating means for heating gas introduction tube (Heating source) 10: Shutter 11: Aperture 12: Gas introduction port

### (Claims 20 through 31)

Fig. 3-1 shows a schematic block diagram of the heat treatment apparatus used for the embodiment 3-1. Fig. 3-2 shows a schematic block diagram of the heat treatment apparatus used for the embodiment 3-2. Fig. 3-3 shows a schematic block diagram of the heat treatment apparatus used for the embodiment 3-2. Fig. 3-4 is a graph showing the hot electron resistance of a MOSFET formed in the embodiment 3-1 and that of a MOSFET formed by the prior art. Fig. 3-5 is a graph showing the sub-threshold characteristic of a MOSFET-type TFT transistor formed in the embodiment 3-1 and that of a MOSFET-type TFT transistor formed by the prior art.

### (Figs. 3-1 to 3-3)

### (Description of references)

1: Furnace tube 2: Gas introduction tube 2a: Branch tube 2b: Branch tube 2c: Mixing portion 304: Furnace tube heating means (Heating source) 5: Silicon substrate (Object to be treated) 6: Susceptor 7: Valve 9: Heating means for heating gas introduction tube (Heating source) 10: shutter 11: Aperture 12: Gas introduction port

### (Claims 32 through 39)

Fig. 4-1 shows a sectional view of the semiconductor device of an embodiment of the present invention. Figs. 4-2 (a) to 4-2 (e) are sectional views showing manufacturing steps of the semiconductor device of the present invention. Fig. 4-3 shows a schematic block diagram of the heat treatment apparatus used for the embodiment 4-2. Fig. 4-5 shows a schematic block diagram of the heat treatment apparatus used for the embodiment 4-3. Fig. 4-6 is a graph showing the hot electron resistance of a MOSFET formed in the embodiment 4-1 and that of a MOSFET formed by the prior art. Fig. 4-7 is a graph showing the sub-threshold characteristic of a MOSFET-type TFT transistor formed in the embodiment 4-1 and that of a MOSFET-type TFT transistor formed by the prior art.

### (Figs. 4-1 to 4-7)

### (Description of references)

11: Electrode on substrate surface 12: p⁺ substrate 13: n⁺ recessed region 14: High-resistance region 15: High-resistivity n⁻ region 16: Discrete region 17 and 18: n⁺ region 19 and 20: p⁺ region 21, 22, 23, and 24: Metal silicide 25 and 26: Silicon oxide film (Gate insulating film) 27 and 28: Gate electrode 29, 30, and 31: Metallic electrode 32, 33, and 34: Metal fluoride (AlF₃) 35: PSG film, Nitride film 301: Furnace tube 302: Gas introduction tube 302a: Branch tube 302b: Branch tube 302c: Mixing portion 304: Furnace tube heating means (Heating source) 305: Silicon substrate (Object to be treated) 306: Susceptor 307: Valve 309: Heating means for heating gas introduction tube (Heating source)

### Best Mode for Carriyng Out the Invention

### (Inventions in claims 1 through 7)

Embodiments of the present invention are described below by referring to the accompanying drawings.

### (Embodiment 1-1)

Fig. 1-1 is a horizontal single-tube oxidation reactor system showing an embodiment of the present invention. In the description of the following embodiments, the same or uniform component is provided with the same symbol. For a furnace tube 1 shown in Fig. 1-1, a hydrogen gas introduction port 12a and an oxygen gas introduction port 12b are formed at one end of the tube 1 in the longitudinal direction of the tube 1, a hydrogen gas introduction tube 2a made of nickel is connected to the hydrogen gas introduction port 12a, and a heating source 9 serving as heating means is set outside the hydrogen gas introduction tube 2a. It is possible to use not only nickel steel but also stainless steel or HASUTEROI as the material of the hydrogen gas introduction tube 2a. That is, any material can be used as long as the material contains nickel. Preferably, a material can be used as long as the material is provided with surface treatment (e.g. dry-oxygen oxidation passive-state-making treatment) not so as to contaminate the inside of the furnace tube 1. A not-illustrated gas supply system is connected to the upstream side of the hydrogen gas introduction tube 2a and the oxygen gas introduction tube 2b through the valves 7 and 8. The heating source 9 comprises an electrical-resistance heater and an infrared-ray lamp heater.

A silicon substrate 5 is mounted on a quartz susceptor 6 serving as a holding member in the furnace tube 1 so that the substrate is heated by a heating source 4. The heating source 4 comprises an electrical-resistance heater and an infrared-ray lamp heater. As the materials of the furnace tube 1 and susceptor 6, not only synthetic quartz and fuzed quarts but also alumina, silicon carbide, aluminum nitride, and boron nitride are listed. Materials not to contaminate a silicon substrate (e.g. sodium-ion-free, heavy-metal-free, degassing-free, and particle-free materials) are preferable.

The silicon substrate 5 is brought into contact with dilute hydrofluoric acid solution to remove a natural oxide film and thereafter washed with extra-pure water and dried. Then, the substrate 5 is set onto the quartz susceptor 6 and transferred into the furnace tube 1 by means of soft landing transfer by opening a lid 10 of an aperture 11 of the furnace tube 1, and the lid 10 is closed. Thereafter, the substrate 5 is heated up to 900°C by the heating source 4. The flow rate of oxygen gas to be introduced into the oxygen gas introduction tube 2b is set to 1,000 cc/min. The flow rate of hydrogen gas to be introduced into the hydrogen gas introduction tube 2a is set to 2,000 cc/min. The introduced hydrogen gas is brought into contact with the inner surface of the hydrogen gas introduction tube 2a heated to 400°C and activated there, and introduced into the furnace tube 1 to produce water vapor by reacting on oxygen gas without combustion at 400°C. It is preferable to keep the temperature of a portion for mixing hydrogen gas or hydrogen activation seeds and oxygen gas at 500°C or lower. When the temperature of the mixing portion is higher than 500°C, combustion occurs, the tip of the quartz tube serving as a hydrogen activation seed introducing portion is melted, and particles are produced. After heating the silicon substrate 5 at 900°C for 120 min, the silicon substrate 5 and the quarts susceptor 6 are taken out of the furnace tube 1 according to the procedure reverse to the soft landing transfer. Then, the particles on the sill after provided with oxidation reaction treatment are measured with, for example, a wafer surface inspecting instrument. As the embodiment, a result is obtained that at least particles with diameters of 0.5 to 5 µm on the silicon wafer after provided with the reaction treatment are not detected.

As the result of taking the silicon substrate 5 and the quarts susceptor 6 out of the furnace tube 1 under the same conditions as those of the above steps except to burn hydrogen at the tip of the quartz tube of the hydrogen gas introducing portion in the furnace tube 1 without heating the hydrogen gas introduction tube 2a, that is, under the conditions of removing a natural oxide film from the silicon substrate 5 with dilute hydrofluoric acid solution, washing it with extra-pure water, drying it, setting it onto the quarts susceptor 6, transferring it by means of soft landing transfer, and heating it in oxygen gas for 120 min at 900°C, 14 particles with diameters of 0.5 to 5 µm are detected on the silicon substrate 5.

The number of particles on an oxide film formed by the apparatus of this embodiment is 1 or less. That is, it is found that the apparatus of the present invention prevents particles from attaching onto the silicon substrate 5.

### (Embodiment 1-2)

Fig. 1-2 shows the embodiment 1-2 in which a portion 2c for mixing hydrogen gas or hydrogen activation seeds and oxygen gas is formed in a gas introduction tube 2. That is, this embodiment uses the gas introduction tube 2 having branch tubes 2a' and 2b' and a portion where the branch tubes 2a' and 2b' meet serves as the mixing portion. The inner surface of the gas introduction tube 2 is made of a nickel alloy (HASUTEROI C).

The constitution and functions of this embodiment are the same as those of the embodiment 1-1 except that the gas mixing portion is formed at a gas introducing section.

That is, in the case of this embodiment, no particle is detected on a silicon substrate 5 taken out of a furnace tube 1 similarly to the case of the embodiment 1-1.

### (Embodiment 1-3)

Fig. 1-3 shows the embodiment 1-3. For this embodiment, a furnace tube 1 is made of nickel (HASUTEROI C).

A heating source 4 heats a silicon substrate 5 serving as an object to be heated through the furnace tube 1.

The flow rate of oxygen gas serving as an introduction gas to be supplied to an oxygen gas introduction port 12b is set to, for example, 1,000 cc/min. The flow rate of hydrogen gas serving as an introduction gas to be supplied to a hydrogen gas introduction port 12a is set to, for example, 10 cc/min, but it does not contact heated nickel while it is introduced into the furnace tube 1. To heat the silicon substrate 5 up to 500°C or higher, it is preferable to set the flow rate of the hydrogen gas so that the hydrogen concentration in the furnace tube 1 comes to 2 vol% or more. When the hydrogen concentration is 2 vol% or more at a temperature of 500°C or higher, hydrogen burns. In the case of this embodiment, at least particles with diameters of 0.5 to 5 µm are not detected on the silicon substrate 5 taken out of the furnace tube after reaction treatment is completed.

For embodiments whose constitution is the same as that of the above embodiments 1-1, 1-2, and 1-3 except that they are formed vertically, their functions are the same as those of the above embodiments. That is, no particle is detected on the silicon substrate 5 taken out of the furnace tube 1 similarly to the case of the above embodiments.

Fig. 1-4 is a graph showing the withstand voltage of an oxide film formed by the apparatus of the present invention and Fig. 1-5 is a graph showing the withstand voltage of an oxide film formed by an existing apparatus. The x axis of the graphs in Figs. 1-4 and 1-5 represents the dielectric breakdown electric field of the oxide film and the y axis of them represents the percentage of the number of oxide films causing dielectric breakdown. The gate electrode uses n⁺ polycrystal silicon, to which a positive voltage is applied.

The oxide film formed by the apparatus of the present invention does not cause dielectric breakdown at an average electric field of oxide films of 8 MV/cm or less. However, the oxide film formed by the existing apparatus causes dielectric breakdown at an average electric field of oxide films of 8 MV/cm or less. That is, it is found that the oxide film formed by the apparatus of the present invention shows a high reliability.

### (Inventions in claims 8 through 19)

Embodiments of the present invention are described below by referring to the accompanying drawings.

### (Embodiment 2-1)

Fig. 2-1 shows an embodiment of the present invention.

The heat treatment apparatus of this embodiment uses a model single-tube sintering furnace system. In the description of the following embodiments, the same or uniform member is provided with the same symbol.

As shown in Fig. 2-1, in the apparatus of this embodiment, a furnace tube 1 has a gas introduction port 12 for introducing gas from the outside at one end in its longitudinal direction and a gas introduction tube 2 is provided outside the furnace tube 1 through the gas introduction port 12.

For this embodiment, the gas introduction tube 2 is made of a nickel alloy (HASUTEROI C: trademark) and a heating source 9 serving as heating means is set outside the gas introduction tube 2.

The material of the gas introduction tube 2 can use not only nickel steel but also stainless steel and HASUTEROI. That is, any materials can be used as long as they contain nickel. It is more preferable that the materials are provided with surface treatment (e.g. dry-oxygen oxidation passive-state-making treatment) not so as to contaminate the inside of the furnace tube 1 as described in the section of embodiments. It is confirmed that the same effect as the case of this embodiment is obtained from these materials.

A not-illustrated gas supply system is connected at the upstream side of the gas introduction tube 2. The heating source 9 comprises an electrical-resistance heater and an infrared-ray lamp heater.

An object to be treated such as a silicon substrate 5 is mounted on a quarts susceptor 6 serving as a holding member in the furnace tube 1 and heated by a heating source 4 serving as furnace tube heating means. The heating source 4 comprises an electrical-resistance heater and an infrared-ray heater. As the materials of the furnace tube 1 and susceptor 6, not only synthetic quartz and fused quartz but also alumina, silicon carbide, aluminum nitride, and boron nitride are listed. It is preferable to use materials not to contaminate a silicon substrate (e.g. sodium-ion-free, heavy-metal-free, degassing-free, and particle-free materials).

The following describes a case in which sintering is carried out by using the apparatus shown in Fig. 2-1.

For this embodiment, a MOS diode before sintering is formed on the silicon substrate 5.

Then, the silicon substrate 5 is set onto the quartz susceptor 6, a lid 10 at an aperture 11 of the furnace tube 1 is opened, the substrate 5 and susceptor 6 are brought into the furnace tube 1 by means of soft landing transfer, and the lid 10 is closed. Then, the silicon substrate 5 is heated up to 300°C by the heating source 4.

A mixed gas of hydrogen gas and argon gas is introduced into the gas introduction tube 2. The mixed gas is made of 10% of hydrogen gas and argon gas and the flow rate of the mixed gas is set to 1,000 cc/min.

The mixed gas of hydrogen gas and argon gas is brought into contact with the inner surface of the gas introduction tube 2 heated to 400°C by the heating source 9 to produce hydrogen activation seeds and the mixed gas and the seeds are introduced into the furnace tube 1 through the gas introduction port 12.

The silicon substrate 5 in the furnace tube 1 is heated to 300°C and the mixed gas is introduced into the furnace tube 1, and thereafter sintering is carried out by keeping the silicon substrate 5 at 300°C for 30 min. The mixed gas containing the hydrogen activation seeds introduced through the gas introduction port 12 contacts the surface of the silicon substrate 5, diffuses in an oxide film, and terminates dangling bonds in the oxide film and on the oxide film/silicon interface.

After sintering, the silicon substrate 5 and quartz susceptor 6 are taken out of the furnace tube 1 by a procedure reverse to the soft landing transfer.

Then, the interface level density of the MOS diode on the sintered silicon substrate 5 is measured by means of the pseudo-constant-volume-voltage measurement. As a result, the interface-level density after sintering shows 2x10⁹cm⁻ ²eV⁻¹ or less.

### (Example for comparison)

As the result of setting the silicon substrate 5 onto the quartz susceptor 6, carrying them by means of soft landing transfer, heating the silicon substrate 5 in the hydrogen-argon mixed gas at 300°C for 30 min, and taking them out by means of the soft landing transfer under the same conditions as the above except to produce no active hydrogen without heating the gas introduction tube 2, the interface level density of the MOS diode on the silicon substrate 5 shows 1x10¹⁰cm⁻²eV⁻¹.
As the result of comparing the above both data values, it is found that the embodiment of the present invention decreases the number of dangling bonds on the oxide film/silicon interface because the interface level density of the oxide film/silicon interface of the embodiment of the present invention is 2x10⁹cm⁻²eV⁻¹ or less as described above.

### (Embodiment 2-2)

Fig. 2-2 shows the embodiment 2-2 in which a portion 2c form mixing hydrogen gas or hydrogen activation seeds and argon gas is formed in a gas introduction tube 2. That is, this embodiment uses a the gas introduction tube 2 having branch tubes 2a and 2b as a gas introduction tube. A portion where the branch tubes 2a and 2b meet serves as the gas mixing portion 2c. In the case of this embodiment, the branch tube 2a is connected to a hydrogen gas source (not illustrated) and the branch tube 2b is connected to an argon gas source (not illustrated). Moreover, for this embodiment, heating means 9 is set closely to the branch tube 2a. Of course, it is also possible to set the means 9 closely to the mixing portion 2c as described above.

The constitution and functions of this embodiment are the same as those of the embodiment 2-1 except that the gas mixing portion is set to the gas introduction tube.

That is, in the case of this embodiment, the interface level density of a MOS diose on a silicon substrate 5 taken out of a furnace tube 1 is 2x10⁹cm⁻²eV⁻¹ or less similarly to the case of the embodiment 1.

### (Embodiment 2-3)

Fig. 2-3 shows the embodiment 2-3. For this embodiment, a furnace tube 1 is made of nickel.

A heating source 4 heats a silicon substrate serving as an object to be heated through the furnace tube 1.

The flow rate of a mixed gas of hydrogen and argon serving as an introduction gas supplied to a gas introduction tube 2 is set to, for example, 1,000 cc/min but it does not contact nickel while it is introduced into the furnace tube 1. In the case of this embodiment, the interface level density of a MOS diode on the silicon substrate 5 taken out of the furnace tube after reaction treatment is 2x10⁹cm⁻²eV⁻¹ or less.

For embodiments whose constitution is the same as that of the embodiments 2-1, 2-2, and 2-3 except that they are vertically constituted, the functions of them are the same as those of the above embodiment. That is, the interface level density of a MOS diode on a silicon substrate 5 taken out of a furnace tube 1 is 2x10⁹cm⁻²eV⁻¹ or less.

Fig. 2-4 is a graph showing the hot electron resistance of a MOSFET formed by the apparatus of the embodiment 2-1 and that of a MOSFET formed by an existing apparatus. The x axis of the graph in Fig. 2-4 represents the number of implanted hot electrons and the y axis of the graph represents the shift of threshold voltage. The thickness of the oxide film is 10 nm. The gate electrode uses n⁺-type polycrystal.

For the MOSFET formed by the apparatus of the embodiment 2-1, the shift of threshold voltage is as low as 0.03 V even though 1x10¹⁷ hot electrons are implanted. For the MOSFET formed by the existing apparatus, however, the shift of threshold voltage is as high as 0.2 V. Therefore, it is found that the MOSFET formed by the apparatus of the embodiment 2-1 shows a high reliability.

Fig. 2-5 is a graph showing the sub-threshold characteristic of a MOSFET-type TFT formed by the apparatus of the embodiment 2-1 and that of a MOSFET-type TFT formed by an existing apparatus. The x axis of the graph in Fig. 2-5 represents the gate voltage and the y axis of it represents the drain current. The substrate used is constituted by forming an oxide film on a silicon wafer and p-type polycrystalline silicon on the oxide film. The MOSFET is formed on the polycrystalline silicon. The polycrystalline silicon is formed not only on the oxide film but also on glass. The gate electrode uses n⁺-type polycrystalline silicon. The MOSFET has the channel length of 2 µm and the channel width of 100 µm. The voltage of 5 V is applied as a drain voltage.

The MOSFET-type TFT formed by the apparatus of the embodiment 1 has a drain current of 1x10⁻¹³ A or less when the gate voltage is 0 V. However, the MOSFET-type TFT formed by the existing apparatus has a drain current of 1x10⁻⁷ A or more even for the gate voltage of 0 V.

In the case of the MOSFET-type TFT formed by the apparatus of the present invention, the drain current decreases because the dangling bonds on the gate oxide film/polycrystalline silicon interface are terminated by hydrogen and also the dangling bonds at the grain boundary of the polycrystalline silicon forming a channel are terminated by hydrogen. Therefore, the sub-threshold characteristic of the MOSFET-type TFT formed by the apparatus of the embodiment 2-1 is improved. That is, it is found that the MOSFET-type TFT formed by the apparatus of the embodiment 1 shows a high performance and a high reliability.

The results same as those shown in Figs. 2-4 and 2-5 are obtained even when treatment is carried out by the apparatuses of the embodiments 2-2 and 2-3.

### (Inventions in claims 20 through 31)

Embodiments of the present invention are described below by referring to the accompanying drawings.

### (Embodiment 3-1)

Fig. 3-1 shows a sintering apparatus used for the embodiment of the present invention.

The sintering apparatus of this embodiment is a model single-tube sintering-furnace system. In the description of the following embodiments, the same or uniform component is provided with the same symbol.

As shown in Fig. 3-1, a furnace tube 1 of the apparatus of this embodiment has a gas introduction port 12 for introducing gas from the outside at one end in its longitudinal direction and a gas introduction tube 2 is provided outside the furnace tube through the gas introduction port 12.

For this embodiment, the gas introduction tube 2 is made of a nickel alloy (HASUTEROI: trademark) and heating source 9 is set outside the gas introduction tube 2.

The material of the gas introduction tube 2 can use not only nickel steel but also stainless steel and HASUTEROI. That is, any materials can be used as long as they contain nickel. It is more preferable that the materials are provided with surface treatment (e.g. dry oxygen oxidation passive-state making treatment) no so as to contaminate the inside of the furnace tube 1 as described in the section of embodiments. It is confirmed that the same result as the case of this embodiment is obtained from these materials.

A not-illustrated gas supply system is connected at the upstream side of the gas introduction tube 2. The heating source 9 comprises an electrical-resistance heater and an infrared-ray lamp heater.

An object to be treated such as a silicon substrate 5 is mounted on a quartz susceptor 6 serving as a holding member in the furnace tube 1 and heated by a heating source 4 serving as furnace tube heating means. The heating source 4 comprises an electrical-resistance heater and an infrared-ray heater. As the materials of the furnace tube 1 and susceptor 6, not only synthetic quartz and fused quartz but also alumina, silicon carbide, aluminum nitride, and boron nitride are listed. It is preferable to use materials not to contaminate a silicon substrate (e.g. sodium-ion-free, heavy-metal-free, degassing-free, and particle-free materials).

The following describes a case in which sintering is carried out by using the apparatus shown in Fig. 3-1.

For this embodiment, a MOS diode before sintering is formed on the silicon substrate 5.

Then, the silicon substrate 5 is set onto the quartz susceptor 6, a lid 10 at an aperture 11 of the furnace tube 1 is opened, the substrate 5 and susceptor 6 are brought into the furnace tube 1 by means of soft landing transfer, and the lid 10 is closed. Then, the silicon substrate 5 is heated up to 300°C by the heating source 4.

A mixed gas of hydrogen gas and argon gas is introduced into the gas introduction tube 2. The mixed gas is made of 10% of hydrogen gas and argon gas and the flow rate of the mixed gas is set to 1,000 cc/min.

The mixed gas of hydrogen gas and argon gas is brought into contact with the inner surface of the gas introduction tube 2 heated to 400°C by the heating source 9 to produce hydrogen activation seeds and the mixed gas and the seeds are introduced into the furnace tube 1 through the gas introduction port 12.

The silicon substrate 5 in the furnace tube 1 is heated to 300°C and the mixed gas is introduced into the furnace tube 1, and thereafter sintering is carried out by keeping the silicon substrate 5 at 300°C for 30 min. The mixed gas containing the hydrogen activation seeds introduced through the gas introduction port 12 contacts the surface of the silicon substrate 5, diffuses in an oxide film, and terminates dangling bonds in the oxide film and on the oxide film/silicon interface.

After sintering, the silicon substrate 5 and quartz susceptor 6 are taken out of the furnace tube 1 by a procedure reverse to the soft landing transfer.

Then, the interface level density of the MOS diode on the sintered silicon substrate 5 is measured by means of the pseudo-constant-volume-voltage measurement. As a result, the interface-level density after sintering shows 2x10⁹cm⁻ ²eV⁻¹ or less.

### (Example for comparison)

As the result of setting the silicon substrate 5 onto the quartz susceptor 6, carrying them by means of soft landing transfer, heating the silicon substrate 5 in the hydrogen-argon mixed gas at 300°C for 30 min, and taking them out by means of the soft landing transfer under the same conditions as the above except to produce no active hydrogen without heating the gas introduction tube 2, the interface level density of the MOS diode on the silicon substrate 5 shows 1x10¹⁰cm⁻²eV⁻¹.
As the result of comparing the above both data values, it is found that the embodiment of the present invention decreases the number of dangling bonds on the oxide film/silicon interface because the interface level density of the oxide film/silicon interface of the embodiment of the present invention is 2x10⁹cm⁻²eV⁻¹ or less as described above.

### (Embodiment 3-2)

The embodiment 3-2 uses the apparatus shown in Fig. 3-2. This apparatus has a portion 2c for mixing hydrogen gas or hydrogen activation seeds and argon gas in the gas introduction tube 2. That is, this embodiment uses a gas introduction tube 2 having branch tubes 2a and 2b as a gas introduction tube. A portion where the branch tubes 2a and 2b meet serves as the gas mixing portion 2c. In the case of this embodiment, the branch tube 2a is connected to a hydrogen gas source (not illustrated) and the branch tube 2b is connected to an argon gas source (not illustrated). Moreover, for this embodiment, heating means 9 is set closely to the branch tube 2a. Of course, it is also possible to set the means 9 closely to the mixing portion 2c as described above. The constitution and functions of this embodiment are the same as those of the embodiment 3-1 except that the gas mixing portion is set to the gas introduction tube.

That is, in the case of this embodiment, the interface level density of a MOS diose on a silicon substrate 5 taken out of a furnace tube 1 is 2x10⁹cm⁻²eV⁻¹ or less similarly to the case of the embodiment 1.

### (Embodiment 3-3)

The embodiment 3-3 uses the apparatus shown in Fig. 3-3. For this apparatus, a furnace tube 1 is made of nickel.

A heating source 4 heats a silicon substrate serving as an object to be heated through the furnace tube 1.

The flow rate of a mixed gas of hydrogen and argon serving as an introduction gas supplied to a gas introduction tube 2 is set to, for example, 1,000 cc/min but it does not contact nickel while it is introduced into the furnace tube 1. In the case of this embodiment, the interface level density of a MOS diode on the silicon substrate 5 taken out of the furnace tube after reaction treatment is 2x10⁹cm⁻²eV⁻¹ or less.

For embodiments whose constitution is the same as that of the embodiments 3-1, 3-2, and 3-3 except that they are vertically constituted, the functions of them are the same as those of the above embodiment. That is, the interface level density of a MOS diode on a silicon substrate 5 taken out of a furnace tube 1 is 2x10⁹cm⁻²eV⁻¹ or less.

Fig. 3-4 is a graph showing the hot electron resistance of a MOSFET formed by the apparatus of the embodiment 3-1 and that of a MOSFET formed by an existing apparatus. The x axis of the graph in Fig. 3-4 represents the number of implanted hot electrons and the y axis of the graph represents the shift of threshold voltage. The thickness of the oxide film is 10 nm. The gate electrode uses n⁺-type polycrystalline silicon.

For the MOSFET formed by the apparatus of the embodiment 3-1, the shift of threshold voltage is as low as 0.03 V even though 1x10¹⁷ hot electrons are implanted. For the MOSFET formed by the existing apparatus, however, the shift of threshold voltage is as high as 0.2 V. Therefore, it is found that the MOSFET formed by the apparatus of the embodiment 3-1 shows a high reliability.

Fig. 3-5 is a graph showing the sub-threshold characteristic of a MOSFET-type TFT formed by the apparatus of the embodiment 3-1 and that of a MOSFET-type TFT formed by an existing apparatus. The x axis of the graph in Fig. 3-5 represents the gate voltage and the y axis of it represents the drain current. The substrate used is constituted by forming an oxide film on a silicon wafer and p-type polycrystalline silicon on the oxide film. The MOSFET is formed on the polycrystalline silicon. The polycrystalline silicon is formed not only on the oxide film but also on glass. The gate electrode uses n⁺-type polycrystalline silicon. The MOSFET has the channel length of 2 µm and the channel width of 100 µm. The voltage of 5 V is applied as a drain voltage.

The MOSFET-type TFT formed by the apparatus of the embodiment 3-1 has a drain current of 1x10⁻¹³ A or less when the gate voltage is 0 V. However, the MOSFET-type TFT formed by the existing apparatus has a drain current of 1x10⁻⁷ A or more even for the gate voltage of 0 V.

In the case of the MOSFET-type TFT formed by the apparatus of the present invention, the drain current decreases because the dangling bonds on the gate oxide film/polycrystalline silicon interface are terminated by hydrogen and also the dangling bonds at the grain boundary of the polycrystalline silicon forming a channel are terminated by hydrogen. Therefore, the sub-threshold characteristic of the MOSFET-type TFT formed by the apparatus of the embodiment 3-1 is improved. That is, it is found that the MOSFET-type TFT formed by the apparatus of the embodiment 1 shows a high performance and a high reliability.

The results same as those shown in Figs. 2-4 and 2-5 are obtained even when treatment is carried out by the apparatuses of the embodiments 3-2 and 3-3.

### (Inventions in claims 32 through 39)

Embodiments of the present invention are described below by referring to the accompanying drawings.

### (Embodiment 4-1)

Fig. 4-1 shows a sectional view of the basic structure of the semiconductor device of this embodiment.

In Fig. 4-1, only a pair of CMOSs included in the semiconductor device are shown. In Fig. 4-1, symbol 11 represents an electrode on the back of a substrate, 12 represents a p⁺ substrate, 13 represents an n⁺ recessed region, 14 represents a high-resistance p⁻ region, 15 represents a high-resistivity n⁻ region, 16 represents a discrete region, 17 and 18 represent n⁺ regions, 19 and 20 represent p⁺ regions, 21, 22, 23, and 24 represent metal silicides made of MoSi₂, WSi₂, TaSi₂, TiSi₂, or Pd₂Si, and 25 and 26 represent sintered silicon oxide films (gate insulating films). The method for sintering the silicon oxide films is described later in detail. Symbols 27 and 28 represent gate electrodes, 30 and 31 represent metallic electrodes made of Al, AlSi, or AlCu, 32, 33, and 34 represent metal fluoride films (AlF₃ is used when Al is used for an electrode) for insulating and separating the electrodes 27, 28, 29, 30, and 31, and 35 represents a PSG film or nitride film for passivation.

In Fig. 4-1, the interface between the gate insulating film 25 and the region 14 is formed at the region-14 side of the interface between the regions 17 and 18 and the region 14 and the interface between the gate insulating film 26 and the region 15 is formed at the region-15 side of the interface between the regions 19 and 20 and the region 15. In the case of this structure, the short-channel effect hardly occurs because an electric field intensity between the source and drain at the channel section is decreased.

In Fig. 4-1, it is preferable to use a material having a high diffusion potential for both the n⁺ regions 17 and 18 and the p⁺ regions 19 and 20 for the material of the gate electrodes 27 and 28. When Al, AlSi, or AlCu is used as the material, a high diffusion potential is obtained. For example, Al has a diffusion potential of approx. 0.7 V for the n⁺ region and a diffusion potential of approx. 0.4 V for the p⁺ region. Of course, any material can be used for a gate electrode as long as the value of the work function of the material has a high barrier for both the n⁺ and p⁺ regions. A refractory metal and metal silicide can also be used. In this case, the gate electrode has a small resistance.

The above structure realizes the normally-off characteristic of a MOS transistor at an impurity density of the channel regions 14 and 15 of approx. 10¹⁴ to 10¹⁶ cm⁻³ because a potential barrier is generated in a channel by the p⁺ substrate 12 for the n⁺ source region and the diffusion potential of the gate electrode 27 and by the n⁺ recessed region 13 for the p⁺ source region and the diffusion potential of the gate electrode 28. That is, the regions 14 and 15 are high-resistance regions in which the impurity concentration is kept low. Therefore, the width of a channel where electrons and holes flow is kept large and a short channel can be realized without decreasing the movement of carriers running through the channel. That is, a large MOS transistor with the conversion conductance of 8 m.

In Fig. 4-1, the junction face between the n⁺ region 17 and the region 14, that between the n⁺ region 18 and the region 14, that between p⁺ region 19 and the region 15, and that between the p⁺ region 20 and the region 15 are planar. Because the junction face area is small, the fringe effect is small and the capacities between the source and drain regions, between the source region and the substrate, and between the drain region and the substrate are small.

In Fig. 4-1, the electrodes 29, 30, and 31 are made of Al, AlSi, AlCu, or AlCuSi and the source and drain electrodes have a small resistance. Because the source, drain, and gate resistances are small, the source and drain capacities are small, and the conversion conductance gₘ is large, a transistor with a high operation speed is obtained. Of course, a metal such as Mo, W, Ta, or Ti can be used for the material of source and drain electrodes.

Though the p⁺ substrate 12 having the n⁺ recessed region 13 is described in Fig. 4-1, the operation of the semiconductor device is also realized by using an insulating substrate made of sapphire, spinel, quartz, AlN, or SiC.

Fig. 4-2 shows a step for fabricating the semiconductor device in Fig. 4-1. A case is described below in which a p⁺ substrate is used for the substrate 12. An n⁺ recessed region is formed in the region 13 of the p⁺ substrate 12 from a PSG film deposited by the CVD method through thermal diffusion of P. Of course, it is also possible to form the region 13 by means of ion implantation of P or As and activation annealing. The discrete regions 16, p⁻ region 14, and n⁻ region 15 are formed as shown below. The surface of the substrate 12 having the recessed region 13 is thermally oxidized up to a depth of several tens of nanometers and thereafter a PSG film or a BPSG film is formed on the surface up to a predetermined depth by the CVD method. The thermal oxide film and the PSG film or the BPSG film on the portions corresponding to the regions 14 and 15 are removed by means of reactive ion etching. Then, the regions 14 and 15 are selectively epitaxial-grown by the CVD method using SiH₄, Si₂H₆, or SiH₂Cl₂. Thus, the structure shown in Fig. 4-2 (a) is formed. However, the structure can be formed by not only the above method but also any other method. It is possible to select the thickness of the regions 14 and 15 depending on the device to be manufactured. For example, it is proper to select a value of 0.03 to 0.5 µm.

Then, a metallic layer with a thickness of 10 to 20 nm made of W, Ta, Ti, or Mo is selectively deposited on the surfaces of the regions 14 and 15. Thereafter, for example, As is selectively implanted into the region 14 and B and Si are selectively implanted into the region 15 by means of ion implantation passing through metallic layers to form silicide layers of regions 21, 22, 23, and 24 and n⁺ regions 17 and 18 and regions 19 and 20 by applying activation annealing as shown in Fig. 4-2 (b).

Then, for example, an Al film with a thickness of 0.2 to 1.0 µm is formed by the sputtering method or CVD method to etch a predetermined region by means of reactive ion etching as shown in Fig. 4-2 (c). The surfaces of regions 29, 30, and 31 are fluoridated, for example, at 100°C for 4 hr using very-high-purity F₂ gas and then annealed in an inert gas (e.g. N₂ gas) at 150°C for 5 hr to form insulating layers made of AlF₃ {regions 32, 33, and 34 in Fig. 4-2 (d)} on the Al region surface. Then, as shown in Fig. 4-2 (d), predetermined regions of the metal silicide layer, n⁺ region, and p⁺ region are etched by means of reactive ion etching by using the regions 32, 33, and 34 as masks to form contact holes.

Then, an oxide film is formed on surfaces exposed from the contact holes by, for example, the thermal oxidation method. That is, as shown in Fig. 4-2 (e), an oxide film is formed on the silicide layer, n⁺ region, p⁺ region, and n⁻ region by means of thermal oxidation.

Then, sintering is carried out as described below. An oxide film and an oxide film/silicon interface with less dangling bonds and a low trap density are formed by the following sintering.

Moreover, the structure of the semiconductor device shown in Fig. 4-1 can be made by forming gate electrodes 27 and 28 to etch predetermined regions of them, forming a passivation layer 35, and forming an electrode 11.

Fig. 4-3 shows a sintering apparatus used for this embodiment.

The sintering apparatus used for this embodiment is a model single-tube sintering furnace system. In the following description, the same or uniform component is provided with the same symbol.

As shown in Fig. 4-3, a furnace tube 301 in the apparatus of this embodiment has a gas introduction port 312 for introducing gas from the outside at one end in its longitudinal direction and a gas introduction tube 302 is provided outside the furnace tube 301 through the gas introduction port 312.

For this embodiment, the gas introduction tube 302 is made of a nickel alloy (HASUTEROI: trademark) and a heating source 9 serving as heating means is set outside the gas introduction tube 302.

The material of the gas introduction tube 302 can use not only nickel steel but also stainless steel and HASUTEROI. That is, any materials can be used as long as they contain nickel. It is more preferable that the materials are provided with surface treatment (e.g. dry oxygen oxidation passive-state making treatment) no so as to contaminate the inside of the furnace tube 301 as described in the section of embodiments. It is confirmed that the same result as the case of this embodiment is obtained from these materials.

A not-illustrated gas supply system is connected at the upstream side of the gas introduction tube 302. The heating source 309 comprises an electrical-resistance heater and an infrared-ray lamp heater.

An object to be treated such as a silicon substrate 305 is mounted on a quartz susceptor 306 serving as a holding member in the furnace tube 301 and heated by a heating source 304 serving as furnace tube heating means. The heating source 304 comprises an electrical-resistance heater and an infrared-ray heater. As the materials of the furnace tube 301 and susceptor 306, not only synthetic quarts and fused quarts but also alumina, silicon carbide, aluminum nitride, and boron nitride are listed. It is preferable to use materials not to contaminate a silicon substrate (e.g. sodium-ion-free, heavy-metal-free, degassing-free, and particle-free materials).

The following describes a case in which sintering is carried out by using the apparatus shown in Fig. 4-3, more specifically.

For this embodiment, a MOS diode before sintering is formed on the silicon substrate 305.

Then, the silicon substrate 305 is set onto the quartz susceptor 306, a lid 310 at an aperture 311 of the furnace tube 301 is opened, the substrate 305 and susceptor 306 are brought into the furnace tube 301 by means of soft landing transfer, and the lid 310 is closed. Then, the silicon substrate 305 is heated up to 300°C by the heating source 304.

A mixed gas of hydrogen gas and argon gas is introduced into the gas introduction tube 302. The mixed gas is made of 10% of hydrogen gas and argon gas and the flow rate of the mixed gas is set to 1,000 cc/min.

The mixed gas of hydrogen gas and argon gas is brought into contact with the inner surface of the gas introduction tube 302 heated to 400°C by the heating source 309 to produce hydrogen activation seeds and the mixed gas and the seeds are introduced into the furnace tube 301 through the gas introduction port 312.

The silicon substrate 305 in the furnace tube 301 is heated to 300°C and the mixed gas is introduced into the furnace tube 301, and thereafter sintering is carried out by keeping the silicon substrate 305 at 300°C for 30 min. The mixed gas containing the hydrogen activation seeds introduced through the gas introduction port 312 contacts the surface of the silicon substrate 305, diffuses in an oxide film, and terminates dangling bonds in the oxide film and on the oxide film/silicon interface.

After sintering, the silicon substrate 305 and quartz susceptor 306 are taken out of the furnace tube 301 by a procedure reverse to the soft landing transfer.

Then, the interface level density of the MOS diode on the sintered silicon substrate 305 is measured by means of the pseudo-constant-volume-voltage measurement. As a result, the interface-level density after sintering shows 2x10⁹cm⁻²eV⁻¹ or less.

### (Example for comparison)

As the result of setting the silicon substrate 305 onto the quartz susceptor 306, carrying them by means of soft landing transfer, heating the silicon substrate 305 in the hydrogen-argon mixed gas at 300°C for 30 min, and taking them out by means of the soft landing transfer under the same conditions as the above except to produce no active hydrogen without heating the gas introduction tube 302, the interface level density of the MOS diode on the silicon substrate 305 shows 1x10¹⁰cm⁻²eV⁻¹.
As the result of comparing the above both data values, it is found that the embodiment of the present invention decreases the number of dangling bonds on the oxide film/silicon interface because the interface level density of the oxide film/silicon interface of the embodiment of the present invention is 2x10⁹cm⁻²eV⁻¹ or less as described above.

After all, because the silicon oxide films (gate oxide films) 25 and 26 are sintered by hydrogen activation seeds free from plasma in Fig. 4-1, the oxide films have a low neutral trap density. Therefor, a transistor with a small shift of threshold voltage and superior in the reliability is obtained even if hot electrons are implanted into the oxide films when the device operates. Moreover, the oxide film/silicon interface sintered by hydrogen activation seeds free from plasma has less dangling bonds and silicon atoms and hydrogen atoms are strongly bonded in the oxide films and on the oxide film/silicon interface. Because the silicon atoms are not disconnected from the hydrogen atoms or a trap in the oxide films and an interface level of the oxide film/silicon interface are not produced even if hot electrons are implanted into the oxide films when the device operates, the conversion conductance does not decrease and a transistor superior in the reliability and keeping a very high operation speed is obtained.

Therefore, it is possible to realize a semiconductor integrated circuit using an insulating-gate transistor with a very high operation speed and superior in the reliability by using the semiconductor device comprising the oxide film formed by the present invention.

### (Embodiment 4-2)

The embodiment 4-2 uses the apparatus shown in Fig. 4-4. This apparatus has a portion 302c for mixing hydrogen gas or hydrogen activation seeds and argon gas in the gas introduction tube 302. That is, this embodiment uses a gas introduction tube 302 having branch tubes 302a and 302b as a gas introduction tube. A portion where the branch tubes 302a and 302b meet serves as the gas mixing portion 302c. In the case of this embodiment, the branch tube 302a is connected to a hydrogen gas source (not illustrated) and the branch tube 302b is connected to an argon gas source (not illustrated). Moreover, for this embodiment, heating means 9 is set closely to the branch tube 302a. Of course, it is also possible to set the means 9 closely to the mixing portion 302c as described above. The constitution and functions of this embodiment are the same as those of the embodiment 4-1 except that the gas mixing portion is set to the gas introduction tube.

That is, in the case of this embodiment, the interface level density of a MOS diose on a silicon substrate 305 taken out of a furnace tube 301 is 2x10⁹cm⁻²eV⁻¹ or less similarly to the case of the embodiment 1.

### (Embodiment 4-3)

The embodiment 4-3 uses the apparatus shown in Fig. 4-5. For this apparatus, a furnace tube 301 is made of nickel.

A heating source 304 heats a silicon substrate serving as an object to be heated through the furnace tube 301.

The flow rate of a mixed gas of hydrogen and argon serving as an introduction gas supplied to a gas introduction tube 302 is set to, for example, 1,000 cc/min but it does not contact nickel while it is introduced into the furnace tube 301. In the case of this embodiment, the interface level density of a MOS diode on the silicon substrate 305 taken out of the furnace tube after reaction treatment is 2x10⁹cm⁻²eV⁻¹ or less.

For embodiments whose constitution is the same as that of the embodiments 4-1, 4-2, and 4-3 except that they are vertically constituted, the functions of them are the same as those of the above embodiment. That is, the interface level density of a MOS diode on a silicon substrate 305 taken out of a furnace tube 301 is 2x10⁹cm⁻²eV⁻¹ or less.

Fig. 4-6 is a graph showing the hot electron resistance of a MOSFET formed by the apparatus of the embodiment 4-1 and that of a MOSFET formed by an existing apparatus. The x axis of the graph in Fig. 4-6 represents the number of implanted hot electrons and the y axis of the graph represents the shift of threshold voltage. The thickness of the oxide film is 10 nm. The gate electrode uses n⁺-type polycrystalline silicon.

For the MOSFET formed by the apparatus of the embodiment 4-1, the shift of threshold voltage is as low as 0.03 V even though 1x10¹⁷ hot electrons are implanted. For the MOSFET formed by the existing apparatus, however, the shift of threshold voltage is as high as 0.2 V. Therefore, it is found that the MOSFET formed by the apparatus of the embodiment 4-1 shows a high reliability.

Fig. 4-7 is a graph showing the sub-threshold characteristic of a MOSFET-type TFT formed by the apparatus of the embodiment 4-1 and that of a MOSFET-type TFT formed by an existing apparatus. The x axis of the graph in Fig. 4-7 represents the gate voltage and the y axis of it represents the drain current. The substrate used is constituted by forming an oxide film on a silicon wafer and p-type polycrystalline silicon on the oxide film. The MOSFET is formed on the polycrystalline silicon. The polycrystalline silicon is formed not only on the oxide film but also on glass. The gate electrode uses n⁺-type polycrystalline silicon. The MOSFET has the channel length of 2 µm and the channel width of 100 µm. The voltage of 5 V is applied as a drain voltage.

The MOSFET-type TFT formed in the embodiment 4-1 has a drain current of 1x10⁻¹³ A or less when the gate voltage is 0 V. However, the MOSFET-type TFT formed by the existing apparatus has a drain current of 1x10⁻⁷ A or more even for the gate voltage of 0 V.

In the case of the MOSFET-type TFT formed by the apparatus of the present invention, the drain current decreases because the dangling bonds on the gate oxide film/polycrystalline silicon interface are terminated by hydrogen and also the dangling bonds at the grain boundary of the polycrystalline silicon forming a channel are terminated by hydrogen. Therefore, the sub-threshold characteristic of the MOSFET-type TFT formed by the apparatus of the embodiment 4-1 is improved. That is, it is found that the MOSFET-type TFT formed by the apparatus of the embodiment 4-1 shows a high performance and a high reliability.

The results same as those shown in Figs. 4-6 and 4-7 are obtained also by the apparatuses of the embodiments 4-2 and 4-3.

The insulating film of the semiconductor device of the present invention can use a film treated in any step as long as the step is a step after forming the film. For example, a film can be used even if it is sintered after the passivation layer 35 is formed. Particularly, when a silicon substrate is exposed to an electron beam and plasma in order to form a fine pattern after an oxide film is formed, the oxide film or an oxide film/silicon interface is damaged and a neutral trap is produced. Even when the oxide film or the oxide film/silicon interface is treated by the existing sintering method, the neutral trap does not disappear. However, when the oxide film or the oxide film/silicon interface is treated by hydrogen activation seeds free from plasma, the neutral trap disappears and the oxide film or the oxide film/silicon interface is recovered from damage.

The above description is mainly made for a single-crystalline silicon surface. However, the present invention can be applied not only to the single-crystalline silicon surface but also any crystalline silicon surface such as a polycrystalline silicon surface or an amorphous silicon surface. In the TFT transistor manufacturing, for example, a high-reliability high-performance TFT transistor is realized by using an oxide film/polycrystalline silicon substrate because the neutral trap in the oxide film and the interface level on the oxide film/polycrystalline silicon interface disappear and moreover the level of the grain boundary in the polycrystalline silicon disappears.

Moreover, in the manufacturing of a semiconductor device locally using nickel or a nickel alloy, the same effect as the method of the present invention can be realized by heating a substrate including nickel or a nickel alloy to 300°C or higher and bringing hydrogen gas or a mixed gas of hydrogen gas and an inert gas into contact with the substrate. For example, when the electrodes 29, 30, and 31 of the semiconductor device shown in Fig. 4-1 are made of nickel or a nickel alloy, it is possible to extinguish the trap in the oxide film and the interface level of the oxide film/silicon interface and realize a semiconductor device superior in the reliability by forming the gate oxide films 25 and 26 and thereafter heating the films to 300°C or higher by the existing sintering method.

### Industrial Applicability

The inventions in claims 1 through 7 make it possible to form a superior oxide film with a high reliability on the solid surface. Therefore, it is possible to realize a very-fine semiconductor device by the apparatus of the present invention having the above feature.

The inventions in claims 8 through 19 make it possible to manufacture a superior MOS transistor with a high reliability on the solid surface. Therefore, it is possible to realize a very-fine semiconductor device by the apparatus of the present invention having the above feature.

The inventions in claims 20 through 31 make it possible to manufacture a semiconductor device with a high reliability. Therefore, it is possible to realize a very-fine semiconductor device by the method of the present invention having the above feature.

The inventions in claims 32 through 39 make it possible to realize a very-fine semiconductor device with a high reliability.

## Claims

1. An apparatus for foming oxide film comprising at least:
a furnace tube having an aperture which can be opened or closed to bring in or out an object to be treated, hydrogen gas introduction port for introducing gas into the tube, and an oxygen gas introduction port for introducing oxygen gas into the tube;
furnace tube heating means for heating the inside of the furnace tube;
a hydrogen gas introduction tube connected through the hydrogen gas introduction port;
an oxygen gas introduction tube connected through the oxygen gas introduction port; and
heating means for heating the hydrogen gas introduction tube; wherein
at least the inner surface of the hydrogen gas introduction tube is made of nickel or a material containing nickel.

2. An apparatus for foming oxide film comprising at least:
a furnace tube having an aperture which can be opened or closed to bring in or out an object to be treated and a gas introduction port for introducing gas into the tube;
furnace tube heating means for heating the inside of the furnace tube;
a gas introduction tube connected through the gas introduction port and having a plurality of branch tubes at the gas source side; and
heating means for heating the branch tubes for introducing hydrogen gas or a gas containing hydrogen gas; wherein
at least the inner surface of some or all of the branch tubes for introducing hydrogen gas or a gas containing hydrogen gas is made of nickel or a material containing nickel.

3. An apparatus for foming oxide film comprising;
a furnace tube having an aperture which can be opened or closed to bring in or out an object to be treated, hydrogen gas introduction port for introducing gas into the tube, and an oxygen gas introduction port for introducing oxygen gas into the tube; and
furnace tube heating means for heating the inside of the furnace tube; wherein
at least the inner surface of the furnace tube at the upstream side of the position where the object to be treated is set is made of nickel or a material containing nickel.

4. The apparatus for foming oxide film according to any one of the claims 1 through 3, wherein the material containing nickel is an Ni-Mo-based alloy or an Ni-W-based alloy.

5. The apparatus for foming oxide film according to any one of the claims 1 through 3, wherein the material containing nickel is stainless steel whose surface is electropolished to a surface roughness of 1 µm or less.

6. The apparatus for foming oxide film according to claim 5, wherein a passive-state film is formed on the surface of the stainless steel as the result of thermal treatment in an oxidizing atmosphere with an impurity concentration of 10 ppb or less.

7. The apparatus for foming oxide film according to claim 5, wherein a passive-state film is formed on the surface of the stainless steel as the result of thermal treatment in an oxidizing atmosphere and deoxidization in a hydrogen atmosphere.

8. A heat treatment apparatus es comprising at least:
a furnace tube having an aperture which can be opened or closed to bring in or out an object to be treated and a gas introduction port for introducing gas into the tube;
furnace tube heating means for heating the inside of the furnace tube; and
hydrogen activation seed producing means for producing hydrogen activation seeds from hydrogen gas or a gas containing hydrogen without causing plasma at the upstream side of the position of an object to be treated set in the furnace tube.

9. A heat treatment apparatus es comprising at least:
a furnace tube having an aperture which can be opened or closed to bring in or out an object to be treated and a gas introduction port for introducing gas into the tube;
furnace tube heating means for heating the inside of the furnace tube;
a gas introduction tube connected through the gas introduction port; and
heating means for heating the gas introduction tube; wherein
at least the inner surface of the gas introduction tube is made of nickel or a material containing nickel.

10. A heat treatment apparatus es comprising at least:
a furnace tube having an aperture which can be opened or closed to bring in or out an object to be treated and a gas introduction port for introducing gas into the tube;
furnace tube heating means for heating the inside of the furnace tube;
a gas introduction tube connected through the gas introduction port and having a plurality of branch tubes at the gas source side; wherein
a part or the whole of at least the inner surface of the gas introduction tube is made of nickel or a material containing nickel.

11. The heat treatment apparatus according to claim 10, wherein at least the inner surfaces of the branch tubes for introducing hydrogen gas or a gas containing hydrogen are made of nickel or a material containing nickel.

12. The heat treatment apparatus according to claim 11, wherein the heating means is arranged so as to heat the branch tubes for introducing hydrogen gas or a gas containing hydrogen.

13. The heat treatment apparatus according to claim 10, wherein the at least the inner surfaces of the range from the portion where the branch tubes meet to the gas introduction port are made of nickel or an alloy containing nickel and the heating means is arranged so as to heat the range.

14. A heat treatment apparatus es comprising:
a furnace tube having an aperture which can be opened or closed to bring in or out an object to be treated and a gas introduction port for introducing gas into the tube; and
furnace tube heating means for heating the inside of the furnace tube; wherein
at least the inner surface of the furnace tube of at least the upstream side of the position where an object to be treated is set is made of nickel or a material containing nickel.

15. The heat treatment apparatus according to any one of the claims 8 through 14, wherein the material containing nickel is an Ni-Mo-based alloy or an Ni-W-based alloy.

16. The heat treatment apparatus according to any one of the claims 8 through 14, wherein the material containing nickel is stainless steel whose surface is electropolished to a surface roughness of 1 µm or less.

17. The heat treatment apparatus according to claim 16, wherein a passive-state film is formed on the surface of the stainless steel as the result of thermal treatment in an oxidizing atmosphere with an impurity concentration of 10 ppb or less.

18. The heat treatment apparatus according to claim 16, wherein a passive-state film is formed on the surface of the stainless steel as the result of thermal treatment in an oxidizing atmosphere and deoxidization in a hydrogen atmosphere.

19. The heat treatment apparatus according to any one of the claims 8 through 18, wherein the heat treatment apparatus is a heat treatment apparatus for terminating dangling bonds on an oxide film/silicon interface.

20. A method for fabricating a semiconductor device having an oxide film/semiconductor interface, comprising the step of bringing hydrogen activation seeds free from plasma into contact with the oxide film.

21. The semiconductor device manufacturing method according to claim 20, wherein the hydrogen activation seeds free from plasma are produced by bringing hydrogen gas or a gas containing hydrogen into contact with a nickel or a material containing nickel heated to 300°C or higher.

22. The semiconductor device manufacturing method according to claim 21, wherein the gas containing hydrogen is a mixed gas of hydrogen gas and an inert gas.

23. The semiconductor device manufacturing method according to claim 22, wherein the inert gas is nitrogen, argon, or a mixed gas of nitrogen and argon.

24. The semiconductor device manufacturing method according to any one of the claims 20 through 23, wherein the insulating film is heated at a temperature of 20 to 1,200°C.

25. The semiconductor device manufacturing method according to claim 24, wherein the insulating film is heated at a temperature of 20 to 600°C.

26. The semiconductor device manufacturing method according to claim 25, wherein the insulating film is heated at a temperature of 20 to 450°C.

27. The semiconductor device manufacturing method according to any one of the claims 20 through 26, wherein the insulating film is a silicon oxide film.

28. The semiconductor device manufacturing method according to claim 27, wherein the silicon oxide film is a silicon thermal oxide film formed by thermal oxidation of silicon, a deposited silicon oxide film, or a film formed by nitration of the silicon thermal oxide film or the deposited silicon oxide film.

29. The semiconductor device manufacturing method according to any one of the claims 20 through 28, wherein the semiconductor is a silicon wafer or a silicon layer formed on an insulating substrate or silicon wafer.

30. The semiconductor device manufacturing method according to claim 29, wherein the silicon layer is an amorphous silicon layer, polycrystalline silicon layer, or single-crystalline silicon layer.

31. The semiconductor device manufacturing method according to claim 21, wherein hydrogen activation seeds are produced by forming a wiring portion of a semiconductor device with nickel or a nickel alloy and bringing hydrogen gas or a gas containing hydrogen into contact with the wiring portion.

32. A semiconductor device having an insulating film sintered by hydrogen activation seeds free from plasma.

33. The semiconductor device according to claim 32, wherein the hydrogen activation seeds are produced by bringing hydrogen gas or a gas containing hydrogen into contact with nickel or a material containing nickel heated to 300°C or higher.

34. The semiconductor device according to claim 32 or 33, wherein the insulating film is a silicon oxide film and the silicon oxide film serves as a gate insulating film of a MOS.

35. The semiconductor device according to claim 32 or 33, wherein the insulating film is a silicon oxide film and the silicon oxide film serves as an inter-layer insulating film of a MOS.

36. The semiconductor device according to claim 32 or 33, wherein the insulating film is a silicon oxide film and the silicon oxide film serves as an insulating film for separating and insulating a gate electrode from a source or drain electrode.

37. The semiconductor device according to any one of the claims 32 through 36, wherein the level density of the interface between the silicon oxide film and silicon is 2x10⁹cm⁻²eV⁻¹ or less.

38. The semiconductor device according to any one of the claims 32 through 37, wherein the silicon oxide film is a silicon thermal oxide film, a deposited silicon oxide film, or a film formed by nitration of the silicon thermal oxide film or the deposited silicon oxide film.

39. The semiconductor device according to claim 38, wherein the silicon layer is an amorphous silicon layer, polycrystalline silicon layer, or single-crystalline silicon layer.
